(19) Europäisches Patentamt
European Patent Office
Office européen des brevets

(11) EP 4 648 318 A1

(12) **EUROPEAN PATENT APPLICATION**
published in accordance with Art. 153(4) EPC

(43) Date of publication:
**12.11.2025 Bulletin 2025/46**

(21) Application number: **23916841.2**

(22) Date of filing: **20.01.2023**

(51) International Patent Classification (IPC):
***H04L 1/00*** *(2006.01)* ***H03M 13/11*** *(2006.01)*

(52) Cooperative Patent Classification (CPC):
**H03M 13/11; H04L 1/00**

(86) International application number:
**PCT/CN2023/073390**

(87) International publication number:
**WO 2024/152363 (25.07.2024 Gazette 2024/30)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Huawei Technologies Co., Ltd.
Shenzhen, Guangdong 518129 (CN)**

(72) Inventors:
- **LIU, Ke
Shenzhen, Guangdong 518129 (CN)**
- **ZHANG, Huazi
Shenzhen, Guangdong 518129 (CN)**
- **TONG, Jiajie
Shenzhen, Guangdong 518129 (CN)**
- **WANG, Jun
Shenzhen, Guangdong 518129 (CN)**

(74) Representative: **Epping - Hermann - Fischer
Patentanwaltsgesellschaft mbH
Schloßschmidstraße 5
80639 München (DE)**

# (54) LDPC CODE-BASED COMMUNICATION METHOD AND COMMUNICATION APPARATUS

(57) This application provides a method for constructing an LDPC base matrix. The LDPC base matrix may be obtained based on a storage matrix and indication information. Specifically, in a process of obtaining the LDPC base matrix, low-code-rate extension includes two manners: conventional extension and split extension. Whether each extension is conventional extension or split extension may be determined by the indication information. Conventional extension can increase an overall edge density of the LDPC base matrix, whereas split extension can reduce the overall edge density of the LDPC base matrix. Therefore, the overall edge density of the LDPC base matrix can be increased through conventional extension and reduced through split extension. This helps maintain an optimal edge density of the LDPC base matrix during low-code-rate extension, to improve performance of an LDPC code.

[FIG. 6]

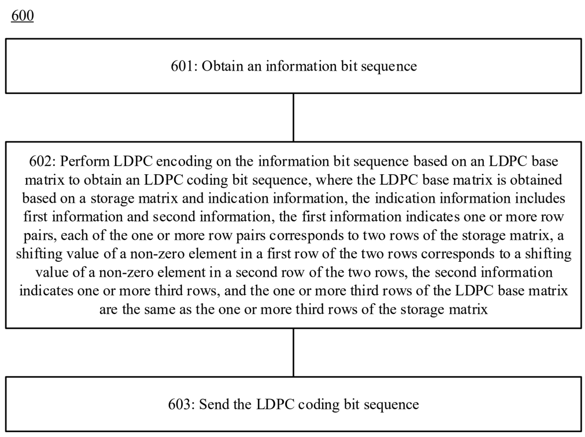


EP 4 648 318 A1

## Description

### TECHNICAL FIELD

This application relates to the coding field, and more specifically, to an LDPC code-based communication method and a communication apparatus.

### BACKGROUND

In the channel coding field, a low-density parity-check (low-density parity-check, LDPC) code is a most mature and widely applied channel coding scheme. A high-code-rate part (namely, a core matrix) of a new radio (new radio, NR) LDPC code supports only parallel decoding of quasi-cyclic (quasi-cyclic, QC) blocks, and cannot support parallel decoding of whole rows. For each code rate of an 802.11ay LDPC code, one check matrix is stored, and a flexible code rate is not supported. Therefore, the 802.11ay LDPC code does not support an incremental redundancy-hybrid automatic repeat request (incremental redundancy-hybrid automatic repeat request, IR-HARQ) mechanism.

### SUMMARY

Embodiments of this application provide an LDPC code-based communication method and a communication apparatus, to help improve performance of an LDPC code.

According to a first aspect, an LDPC code-based communication method is provided. The method may be performed by a transmit end, or a module or unit (for example, a chip) in the transmit end, hereinafter collectively referred to as the transmit end for ease of description. Optionally, the transmit end may be a terminal or a network device.

The method includes: obtaining an information bit sequence; performing LDPC encoding on the information bit sequence based on an LDPC base matrix to obtain an LDPC coding bit sequence; and sending the LDPC coding bit sequence. The LDPC base matrix is obtained based on a storage matrix and indication information. The indication information includes first information and second information. The first information indicates one or more row pairs. Each of the one or more row pairs corresponds to two rows of the storage matrix. A shifting value of a non-zero element in a first row of the two rows corresponds to a shifting value of a non-zero element in a second row of the two rows. The second information indicates one or more third rows. The one or more third rows of the LDPC base matrix are the same as the one or more third rows of the storage matrix. That the one or more third rows of the LDPC base matrix are the same as the one or more third rows of the storage matrix may be understood as that a connection relationship, an edge, or a non-zero element in the one or more third rows of the LDPC base matrix is the same as a connection relationship, an edge, or a non-zero element in the one or more third rows of the storage matrix, and a shifting value of the non-zero element in the one or more third rows of the LDPC base matrix is the same as a shifting value of the non-zero element in the one or more third rows of the storage matrix.

In the foregoing method, the LDPC base matrix may be obtained based on the storage matrix and the indication information. The indication information includes two types of information. One type of information indicates one or more row pairs. Two rows corresponding to each row pair are two rows in which shifting values of non-zero elements have a correspondence. The other type of information indicates one or more rows. Therefore, the indication information can indicate two different low-code-rate extension manners through the two types of information. In other words, in a process of obtaining the LDPC base matrix, there are two low-code-rate extension manners, and which of the two manners is used for an extension can be determined through the indication information. In this way, in a process of obtaining the LDPC base matrix through low-code-rate extension, in comparison with a process in which only one low-code-rate extension manner is used, low-code-rate extension in the foregoing method is more flexible, to help obtain an LDPC base matrix with better performance.

With reference to the first aspect, in some implementations of the first aspect, a row that is of the LDPC base matrix and that corresponds to the first row is the same as the first row; and a row that is of the LDPC base matrix and that corresponds to the second row is obtained by performing elimination on the second row with the first row.

In this way, after the row that is of the LDPC base matrix and that corresponds to the first row is extended, a column weight of a non-extended column of the LDPC base matrix does not change. An overall edge density of the LDPC base matrix can be reduced based on this extension manner (also referred to as split extension). A row that is of the LDPC base matrix and that corresponds to the third row indicated by the second information is the same as the third row of the storage matrix. The overall edge density of the LDPC base matrix can be increased based on this extension manner (also referred to as conventional extension). Therefore, the overall edge density of the LDPC base matrix can be increased through conventional extension and reduced through split extension. This helps maintain an optimal edge density of the LDPC base matrix during low-code-rate extension, to improve performance of the LDPC code.

With reference to any one of the first aspect or the implementations of the first aspect, in some other implementations of the first aspect, the storage matrix is obtained based on a first table, a second table, and a third table. The first table includes a connection relationship between a variable node and a check node of the storage matrix. The second table includes a shifting value of a non-zero element in a core matrix of the storage matrix. The third table includes a shifting value of a non-zero element in the one or more third rows.

In the foregoing method, only the shifting value of the non-zero element in the core matrix of the storage matrix and the shifting value of the non-zero element in the one or more third rows may be stored, to help reduce occupied storage space.

With reference to any one of the first aspect or the implementations of the first aspect, in some other implementations of the first aspect, a form used for the indication information includes at least one of an indication sequence, a mapping table, or a mapping pair.

With reference to any one of the first aspect or the implementations of the first aspect, in some other implementations of the first aspect, the indication information is in a form of an indication sequence. A length of the indication sequence is equal to a quantity of rows of the LDPC base matrix. The first information includes a row number of a second row in each of the one or more row pairs. A row number of a first row in the row pair is a position of the row number of the second row in the row pair in the indication sequence. The position of the row number of the second row in the row pair in the indication sequence is greater than the row number of the first row in the row pair. The second information includes one or more first characters. Positions of the one or more first characters in the indication sequence correspond to row numbers of the one or more third rows.

With reference to any one of the first aspect or the implementations of the first aspect, in some other implementations of the first aspect, the first character is a value other than a row number of the storage matrix. The first character is set to the value other than the row number of the storage matrix, so that the first character can be well distinguished from the row number in the first information.

With reference to any one of the first aspect or the implementations of the first aspect, in some other implementations of the first aspect, the second information includes a plurality of first characters, and values of the plurality of first characters are the same.

Optionally, some or all of a plurality of third rows corresponding to the plurality of first characters are pairwise orthogonal.

With reference to any one of the first aspect or the implementations of the first aspect, in some other implementations of the first aspect, the second information includes a plurality of first characters, the plurality of first characters include at least two types of values, and third rows corresponding to first characters with a same value are pairwise orthogonal.

Setting the third rows corresponding to the first characters with the same value to be pairwise orthogonal helps slow down an increase in a quantity of equivalent decoded rows.

With reference to any one of the first aspect or the implementations of the first aspect, in some other implementations of the first aspect, the indication sequence sequentially includes a first segment, a second segment, a third segment, and a fourth segment. The first segment corresponds to the core matrix of the storage matrix. The first segment consists of one or more first row numbers or one or more second characters. The second segment consists of one or more third characters. The third segment consists of one or more second row numbers. The fourth segment is formed by interleaving one or more fourth characters and one or more third row numbers. The row number in the first information sequentially includes the one or more first row numbers, the one or more second row numbers, and the one or more third row numbers. The one or more first characters sequentially include the one or more second characters, the one or more third characters, and the one or more fourth characters.

Based on the foregoing indication sequence, it is helpful to ensure that the optimal edge density is maintained during each extension.

With reference to any one of the first aspect or the implementations of the first aspect, in some other implementations of the first aspect, when the first segment consists of the one or more first row numbers, the one or more second row numbers include at least one or all of the one or more first row numbers.

With reference to any one of the first aspect or the implementations of the first aspect, in some other implementations of the first aspect, the one or more third row numbers include at least one or all of row numbers of third rows corresponding to the one or more fourth characters.

With reference to any one of the first aspect or the implementations of the first aspect, in some other implementations of the first aspect, a proportion of the fourth characters in the fourth segment increases as a code rate corresponding to the LDPC base matrix decreases.

Based on the foregoing method, it is helpful to support a lower code rate.

With reference to any one of the first aspect or the implementations of the first aspect, in some other implementations of the first aspect, an $i^{th}$ position of the indication sequence is the first character. A quantity of pairwise orthogonal third rows in first i rows of the storage matrix is less than or equal to a sum of 1 and a maximum quantity of splitting times of (i - 1) rows corresponding to first (i - 1) positions of the indication sequence. i is an integer greater than 1. A quantity of splitting times of a row is a total quantity of splitting times of the row and a row generated by splitting the row. The row generated by splitting the row includes a row directly or indirectly generated by splitting the row.

For example, if a row #3 is split to generate rows #5 and #9, the row #5 is split to generate a row #7, and the row #7 is split to generate a row #19, the rows #5 and #9 are rows directly obtained by splitting the row #3, the rows #7 and #19 are rows indirectly obtained by splitting the row #3, a quantity of splitting times of the row #3 is 4, a quantity of splitting times of the row #5 is 2, a quantity of splitting times of the row #7 is 1, and quantities of splitting times of the rows #9 and #19 are 0.

Based on the foregoing method, the quantity of equivalent decoded rows can slowly increase as the code rate of the LDPC base matrix decreases, leading to as little additional hardware complexity as possible.

With reference to any one of the first aspect or the implementations of the first aspect, in some other implementations of the first aspect, the storage matrix is an M × N matrix. The storage matrix includes a submatrix A1, a submatrix B1, a submatrix C1, a submatrix D1, and a submatrix E1. The submatrix A1 is $1^{st}$ to $m_1^{th}$ rows and $1^{st}$ to $n_1^{th}$ columns of the storage matrix. The submatrix B1 is the $1^{st}$ to $m_1^{th}$ rows and $(n_1 + 1)^{th}$ to $n_2^{th}$ columns of the storage matrix. The submatrix C1 is the $1^{st}$ to $m_1^{th}$ rows and $(n_2 + 1)^{th}$ to $N^{th}$ columns of the storage matrix. The submatrix D1 is $(m_1 + 1)^{th}$ to $M^{th}$ rows and the $1^{st}$ to $n_2^{th}$ columns of the storage matrix. The submatrix E1 is the $(m_1 + 1)^{th}$ to $M^{th}$ rows and the $(n_2 + 1)^{th}$ to $N^{th}$ columns of the storage matrix. That the shifting value of the non-zero element in the first row corresponds to the shifting value of the non-zero element in the second row includes: shifting values of non-zero elements in first $n_2$ elements of the first row correspond to shifting values of non-zero elements in first $n_2$ elements of the second row. The first $n_2$ elements of the second row are rows in a matrix formed by the submatrix A1 and the submatrix B1 or rows in the submatrix D1.

With reference to any one of the first aspect or the implementations of the first aspect, in some other implementations of the first aspect, that the shifting values of the non-zero elements in the first $n_2$ elements of the first row correspond to the shifting values of the non-zero elements in the first $n_2$ elements of the second row includes: the shifting values of the non-zero elements in the first $n_2$ elements of the first row are properly included in the shifting values of the non-zero elements in the first $n_2$ elements of the second row; or sums of a fixed value and the shifting values of the non-zero elements in the first $n_2$ elements of the first row are properly included in the shifting values of the non-zero elements in the first $n_2$ elements of the second row.

With reference to any one of the first aspect or the implementations of the first aspect, in some other implementations of the first aspect, the submatrix E1 is a lower triangular matrix.

With reference to any one of the first aspect or the implementations of the first aspect, in some other implementations of the first aspect, a sum of column weights of a core part of the LDPC base matrix is less than a sum of column weights of a part that is of the storage matrix and that corresponds to the core part of the LDPC base matrix; and/or a sum of column weights of an extended part of the LDPC base matrix is greater than a sum of column weights of a part that is of the storage matrix and that corresponds to the extended part of the LDPC base matrix.

With reference to any one of the first aspect or the implementations of the first aspect, in some other implementations of the first aspect, the LDPC base matrix is an X × Y matrix. The LDPC base matrix includes a submatrix A2, a submatrix B2, a submatrix C2, a submatrix D2, and a submatrix E2. The submatrix A2 is $1^{st}$ to $x_1^{th}$ rows and $1^{st}$ to $y_1^{th}$ columns of the LDPC base matrix. The submatrix B2 is the $1^{st}$ to $x_1^{th}$ rows and $(y_1 + 1)^{th}$ to $y_2^{th}$ columns of the LDPC base matrix. The submatrix C2 is the $1^{st}$ to $x_1^{th}$ rows and $(y_2 + 1)^{th}$ to $Y^{th}$ columns of the LDPC base matrix. The submatrix D2 is $(x_1 + 1)^{th}$ to $X^{th}$ rows and the $1^{st}$ to $y_2^{th}$ columns of the LDPC base matrix. The submatrix E2 is the $(x_1 + 1)^{th}$ to $X^{th}$ rows and the $(y_2 + 1)^{th}$ to $Y^{th}$ columns of the LDPC base matrix. $1 \leq x_1 \leq X$. $1 \leq y_1 \leq y_2 \leq Y$. $x_1$, X, $y_1$, $y_2$, and Y are integers. An element on a diagonal of the submatrix E2 is a non-zero element. The submatrix E2 includes a non-zero element above its diagonal, and/or the submatrix E2 includes a non-zero element below its diagonal. The submatrix C2 includes a non-zero element.

Based on the foregoing method, the submatrix C2 includes a non-zero element. This helps avoid an error floor caused by a small degree of an extended node (namely, column weight of an extended column). Further, when the submatrix E2 also includes a non-zero element above its diagonal, the error floor caused by the small degree of the extended node can be further avoided.

With reference to any one of the first aspect or the implementations of the first aspect, in some other implementations of the first aspect, the method further includes: reading the indication information whose length is R based on a code length corresponding to the LDPC base matrix, a quantity of information bits corresponding to the LDPC base matrix, a quantity of punctured information columns, and a quantity of information columns in the LDPC base matrix; and obtaining the LDPC base matrix based on the storage matrix and the indication information. R is a minimum integer that meets a condition $RZ_c \geq N_0 - K_0 + K_1$. $Z_c$ is a lifting value. $Z_c$ is minimum $Z_c$ that meets a condition $KZ_c \geq K_0$ in a $Z_c$ list. $N_0$ is the code length corresponding to the LDPC base matrix. $K_0$ is the quantity of information bits corresponding to the LDPC base matrix. K is the quantity of information columns in the LDPC base matrix. $K_1$ is the quantity of punctured information columns.

According to a second aspect, an LDPC code-based communication method is provided. The method may be performed by a receive end, or a module or unit (for example, a chip) in the receive end, hereinafter collectively referred to as the receive end for ease of description. Optionally, the receive end may be a terminal or a network device.

For technical effects of the method shown in the second aspect and the possible implementations of the second aspect, refer to the first aspect and the possible implementations of the first aspect. Details are not described again.

The method includes: receiving an LDPC coding bit sequence from a transmit end; and decoding the LDPC coding bit sequence based on an LDPC base matrix. The LDPC base matrix is obtained based on a storage matrix and indication information. The indication information includes first information and second information. The first information indicates one or more row pairs. Each of the one or more row pairs corresponds to two rows of the storage matrix. A shifting value of a non-zero element in a first row of the two rows corresponds to a shifting value of a non-zero element in a second row of the two rows. The second information indicates one or more third rows. The one or more third rows of the LDPC base matrix are the same as the one or more third rows of the storage matrix.

With reference to the second aspect, in some implementations of the second aspect, a row that is of the LDPC base matrix and that corresponds to the first row is the same as the first row; and a row that is of the LDPC base matrix and that corresponds to the second row is obtained by performing elimination on the second row with the first row.

With reference to any one of the second aspect or the implementations of the second aspect, in some other implementations of the second aspect, the storage matrix is obtained based on a first table, a second table, and a third table. The first table includes a connection relationship between a variable node and a check node of the storage matrix. The second table includes a shifting value of a non-zero element in a core matrix of the storage matrix. The third table includes a shifting value of a non-zero element in the one or more third rows.

With reference to any one of the second aspect or the implementations of the second aspect, in some other implementations of the second aspect, a form used for the indication information includes at least one of an indication sequence, a mapping table, or a mapping pair.

With reference to any one of the second aspect or the implementations of the second aspect, in some other implementations of the second aspect, the indication information is in a form of an indication sequence. A length of the indication sequence is equal to a quantity of rows of the LDPC base matrix. The first information includes a row number of a second row in each of the one or more row pairs. A row number of a first row in the row pair is a position of the row number of the second row in the row pair in the indication sequence. The position of the row number of the second row in the row pair in the indication sequence is greater than the row number of the first row in the row pair. The second information includes one or more first characters. Positions of the one or more first characters in the indication sequence correspond to row numbers of the one or more third rows.

With reference to any one of the second aspect or the implementations of the second aspect, in some other implementations of the second aspect, the first character is a value other than a row number of the storage matrix.

With reference to any one of the second aspect or the implementations of the second aspect, in some other implementations of the first aspect, the second information includes a plurality of first characters, and values of the plurality of first characters are the same.

Optionally, some or all of a plurality of third rows corresponding to the plurality of first characters are pairwise orthogonal.

With reference to any one of the second aspect or the implementations of the second aspect, in some other implementations of the second aspect, the second information includes a plurality of first characters, the plurality of first characters include at least two types of values, and third rows corresponding to first characters with a same value are pairwise orthogonal.

With reference to any one of the second aspect or the implementations of the second aspect, in some other implementations of the second aspect, the indication sequence sequentially includes a first segment, a second segment, a third segment, and a fourth segment. The first segment corresponds to the core matrix of the storage matrix. The first segment consists of one or more first row numbers or one or more second characters. The second segment consists of one or more third characters. The third segment consists of one or more second row numbers. The fourth segment is formed by interleaving one or more fourth characters and one or more third row numbers. The row number in the first information sequentially includes the one or more first row numbers, the one or more second row numbers, and the one or more third row numbers. The one or more first characters sequentially include the one or more second characters, the one or more third characters, and the one or more fourth characters.

With reference to any one of the second aspect or the implementations of the second aspect, in some other implementations of the first aspect, when the first segment consists of the one or more first row numbers, the one or more second row numbers include at least one or all of the one or more first row numbers.

With reference to any one of the second aspect or the implementations of the second aspect, in some other implementations of the first aspect, the one or more third row numbers include at least one or all of row numbers of third rows corresponding to the one or more fourth characters.

With reference to any one of the second aspect or the implementations of the second aspect, in some other implementations of the second aspect, a proportion of the fourth characters in the fourth segment increases as a code rate corresponding to the LDPC base matrix decreases.

With reference to any one of the second aspect or the implementations of the second aspect, in some other implementations of the second aspect, an $i^{th}$ position of the indication sequence is the first character. A quantity of pairwise orthogonal third rows in first i rows of the storage matrix is less than or equal to a sum of 1 and a maximum quantity of splitting times of (i - 1) rows corresponding to first (i - 1) positions of the indication sequence. i is an integer greater than 1. A quantity of splitting times of a row is a total quantity of splitting times of the row and a row generated by splitting the row. The row generated by splitting the row includes a row directly or indirectly generated by splitting the row.

With reference to any one of the second aspect or the implementations of the second aspect, in some other implementations of the second aspect, the storage matrix is an $M \times N$ matrix. The storage matrix includes a submatrix A1, a submatrix B1, a submatrix C1, a submatrix D1, and a submatrix E1. The submatrix A1 is $1^{st}$ to $m_1^{th}$ rows and $1^{st}$ to $n_1^{th}$ columns of the storage matrix. The submatrix B1 is the $1^{st}$ to $m_1^{th}$ rows and $(n_1 + 1)^{th}$ to $n_2^{th}$ columns of the storage matrix. The submatrix C1 is the $1^{st}$ to $m_1^{th}$ rows and $(n_2 + 1)^{th}$ to $N^{th}$ columns of the storage matrix. The submatrix D1 is $(m_1 + 1)^{th}$ to $M^{th}$ rows and the $1^{st}$ to $n_2^{th}$ columns of the storage matrix. The submatrix E1 is the $(m_1 + 1)^{th}$ to $M^{th}$ rows and the $(n_2 + 1)^{th}$ to $N^{th}$ columns of the storage matrix. That the shifting value of the non-zero element in the first row corresponds to the shifting value of the non-zero element in the second row includes: shifting values of non-zero elements in first $n_2$ elements of the first row correspond to shifting values of non-zero elements in first $n_2$ elements of the second row. The first $n_2$ elements of the second row are rows in a matrix formed by the submatrix A1 and the submatrix B1 or rows in the submatrix D1.

With reference to any one of the second aspect or the implementations of the second aspect, in some other implementations of the second aspect, that the shifting values of the non-zero elements in the first $n_2$ elements of the first row correspond to the shifting values of the non-zero elements in the first $n_2$ elements of the second row includes: the shifting values of the non-zero elements in the first $n_2$ elements of the first row are properly included in the shifting values of the non-zero elements in the first $n_2$ elements of the second row; or sums of a fixed value and the shifting values of the non-zero elements in the first $n_2$ elements of the first row are properly included in the shifting values of the non-zero elements in the first $n_2$ elements of the second row.

With reference to any one of the second aspect or the implementations of the second aspect, in some other implementations of the second aspect, the submatrix E1 is a lower triangular matrix.

With reference to any one of the second aspect or the implementations of the second aspect, in some other implementations of the second aspect, a sum of column weights of a core part of the LDPC base matrix is less than a sum of column weights of a part that is of the storage matrix and that corresponds to the core part of the LDPC base matrix; and/or a sum of column weights of an extended part of the LDPC base matrix is greater than a sum of column weights of a part that is of the storage matrix and that corresponds to the extended part of the LDPC base matrix.

With reference to any one of the second aspect or the implementations of the second aspect, in some other implementations of the second aspect, the LDPC base matrix is an $X \times Y$ matrix. The LDPC base matrix includes a submatrix A2, a submatrix B2, a submatrix C2, a submatrix D2, and a submatrix E2. The submatrix A2 is $1^{st}$ to $x_1^{th}$ rows and $1^{st}$ to $y_1^{th}$ columns of the LDPC base matrix. The submatrix B2 is the $1^{st}$ to $x_1^{th}$ rows and $(y_1 + 1)^{th}$ to $y_2^{th}$ columns of the LDPC base matrix. The submatrix C2 is the $1^{st}$ to $x_1^{th}$ rows and $(y_2 + 1)^{th}$ to $Y^{th}$ columns of the LDPC base matrix. The submatrix D2 is $(x_1 + 1)^{th}$ to $X^{th}$ rows and the $1^{st}$ to $y_2^{th}$ columns of the LDPC base matrix. The submatrix E2 is the $(x_1 + 1)^{th}$ to $X^{th}$ rows and the $(y_2 + 1)^{th}$ to $Y^{th}$ columns of the LDPC base matrix. $1 \leq x_1 \leq X$. $1 \leq y_1 \leq y_2 \leq Y$. $x_1$, $X$, $y_1$, $y_2$, and $Y$ are integers. An element on a diagonal of the submatrix E2 is a non-zero element. The submatrix E2 includes a non-zero element above its diagonal, and/or the submatrix E2 includes a non-zero element below its diagonal. The submatrix C2 includes a non-zero element.

With reference to any one of the second aspect or the implementations of the second aspect, in some other implementations of the second aspect, the method further includes: reading the indication information whose length is R based on a code length corresponding to the LDPC base matrix, a quantity of information bits corresponding to the LDPC base matrix, a quantity of punctured information columns, and a quantity of information columns in the LDPC base matrix; and obtaining the LDPC base matrix based on the storage matrix and the indication information. R is a minimum integer that meets a condition $RZ_c \geq N_0 - K_0 + K_1$. $Z_c$ is a lifting value. $Z_c$ is minimum $Z_c$ that meets a condition $KZ_c \geq K_0$ in a $Z_c$ list. $N_0$ is the code length corresponding to the LDPC base matrix. $K_0$ is the quantity of information bits corresponding to the LDPC base matrix. K is the quantity of information columns in the LDPC base matrix. $K_1$ is the quantity of punctured information columns.

According to a third aspect, a communication apparatus is provided. The apparatus is configured to perform the method provided in any one of the foregoing aspects or the implementations of the foregoing aspects. Specifically, the apparatus may include a unit and/or a module configured to perform the method provided in any one of the foregoing aspects or the implementations of the foregoing aspects, for example, a processing unit and/or a communication unit.

In an implementation, the apparatus is a transmit end or a receive end. When the apparatus is the transmit end or the receive end, the communication unit may be a transceiver, an input/output interface, or a communication interface; and the processing unit may be at least one processor. Optionally, the transceiver is a transceiver circuit. Optionally, the input/output interface is an input/output circuit.

In another implementation, the apparatus is a chip, a chip system, or a circuit used at a transmit end or a receive end. When the apparatus is the chip, the chip system, or the circuit used at the transmit end or the receive end, the communication unit may be an input/output interface, an interface circuit, an output circuit, an input circuit, a pin, a related circuit, or the like on the chip, the chip system, or the circuit; and the processing unit may be at least one processor, processing circuit, logic circuit, or the like.

According to a fourth aspect, a communication apparatus is provided. The apparatus includes: a memory, configured to store a program; and at least one processor, configured to execute a computer program or instructions stored in the memory, to perform the method provided in any one of the foregoing aspects or the implementations of the foregoing aspects.

In an implementation, the apparatus is a transmit end or a receive end.

In another implementation, the apparatus is a chip, a chip system, or a circuit used at a transmit end or a receive end.

According to a fifth aspect, a communication apparatus is provided. The apparatus includes at least one processor and a communication interface. The at least one processor is configured to obtain, through the communication interface, a computer program or instructions stored in a memory, to perform the method provided in any one of the foregoing aspects or the implementations of the foregoing aspects. The communication interface may be implemented by hardware or software.

In an implementation, the apparatus further includes the memory.

According to a sixth aspect, a processor is provided, and is configured to perform the methods provided in the foregoing aspects.

Unless otherwise specified, or if operations such as sending and obtaining/receiving related to the processor do not conflict with actual functions or internal logic in related descriptions, the operations may be understood as operations such as output, receiving, and input of the processor, or may be understood as operations such as sending and receiving performed by a radio frequency circuit and an antenna. This is not limited in this application.

According to a seventh aspect, a computer-readable storage medium is provided. The computer-readable medium stores program code to be executed by a device. The program code is used to perform the method provided in any one of the foregoing aspects or the implementations of the foregoing aspects.

According to an eighth aspect, a computer program product including instructions is provided. When the computer program product runs on a computer, the computer is enabled to perform the method provided in any one of the foregoing aspects or the implementations of the foregoing aspects.

According to a ninth aspect, a chip is provided. The chip includes a processor and a communication interface. The processor reads, through the communication interface, instructions stored in a memory, to perform the method provided in any one of the foregoing aspects or the implementations of the foregoing aspects. The communication interface may be implemented by hardware or software.

Optionally, in an implementation, the chip further includes the memory. The memory stores a computer program or the instructions. The processor is configured to execute the computer program or the instructions stored in the memory. When the computer program is executed or the instructions are executed, the processor is configured to perform the method provided in any one of the foregoing aspects or the implementations of the foregoing aspects.

When the method provided in this application is performed by the chip, a quantity of chips that specifically implement the method of this application is not limited in this application. For example, the method may be performed by one chip, or may be performed by two or more chips. In addition, when there are two or more chips that implement the method of this application, a chip vendor is not limited. The chips may be from a same vendor or from different vendors.

According to a tenth aspect, a communication system is provided, and includes the foregoing transmit end and/or receive end.

According to an eleventh aspect, a computer program is provided. The computer program, when run on a computer, enables the method provided in any one of the foregoing aspects or the implementations of the foregoing aspects to be performed.

## BRIEF DESCRIPTION OF DRAWINGS

FIG. 1 is a diagram of a communication scenario to which an embodiment of this application is applicable;
FIG. 2 is a diagram of a check matrix H of LDPC;
FIG. 3 is a Tanner graph of a check matrix H of LDPC;
FIG. 4 is a diagram of a structure of a parity-check matrix of 5G NR LDPC;
FIG. 5 is a diagram of an information transmission procedure;
FIG. 6 is a schematic flowchart of an LDPC code-based communication method 600 according to this application;
FIG. 7 is a diagram of extension manners according to this application;
FIG. 8 is a diagram of column weight distribution of a storage matrix according to this application;
FIG. 9 shows an example of content stored at a transmit end;

FIG. 10 shows two examples of indication sequences according to this application;
FIG. 11 is a schematic flowchart of an LDPC code-based communication method 1100 according to this application;
FIG. 12 shows a simulation result of a quantity of equivalent decoded rows of an LDPC code according to an embodiment of this application;
FIG. 13 shows a simulation result of an average quantity of decoding iterations of an LDPC code according to an embodiment of this application;
FIG. 14 shows a simulation result of an aligned quantity of equivalent decoded rows of an LDPC code according to an embodiment of this application;
FIG. 15 shows a simulation result of an error floor of an LDPC code according to an embodiment of this application;
FIG. 16 shows a simulation result of performance of an LDPC code in low-bit quantization according to an embodiment of this application;
FIG. 17 is a diagram of a structure of an apparatus according to an embodiment of this application; and
FIG. 18 is a diagram of another structure of an apparatus according to an embodiment of this application.

## DESCRIPTION OF EMBODIMENTS

For ease of understanding of embodiments of this application, before embodiments of this application are described, the following descriptions are first provided.

In this application, "indicating" or "indicate" may include a direct indication and an indirect indication, or "indicating" or "indicate" may be an explicit indication and/or an implicit indication. For example, when a piece of indication information is described as indicating information I, the indication information may directly indicate I or indirectly indicate I, but it does not necessarily indicate that the indication information carries I. For another example, the implicit indication may be based on a location and/or a resource used for transmission; and the explicit indication may be based on one or more parameters, and/or one or more indexes, and/or one or more bit patterns represented by the explicit indication.

Definitions listed for many features in this application are merely used to explain functions of the features by using examples. For detailed content of the definitions, refer to the conventional technology.

In the following embodiments, first, second, third, fourth, and various numbers are merely used for differentiation for ease of description, but are not used to limit the scope of embodiments of this application. For example, the numbers are used to differentiate between different characters, different information, and the like.

"Predefinition" may be implemented by pre-storing corresponding code or a corresponding table in a device, or may be implemented in another manner that may be used for indicating related information. A specific implementation of "predefinition" is not limited in this application. "Storing" may be storage in one or more memories. A type of the memory may be a storage medium in any form. This is not limited in this application.

A "protocol" in embodiments of this application may be a standard protocol in the communication field, for example, may include a long term evolution (long term evolution, LTE) protocol, a new radio (new radio, NR) protocol, and a related protocol applied to a future communication system. This is not limited in this application.

Each aspect, embodiment, or feature is presented in this application with reference to a system including a plurality of devices, components, modules, and the like. It should be appreciated and understood that each system may include another device, component, module, and the like, and/or may not include all devices, components, modules, and the like discussed with reference to the accompanying drawings. In addition, a combination of these solutions may be used.

In embodiments of this application, words such as "example", "for example", and "in an (another) example" are used to represent giving an example, an illustration, or a description. Any embodiment or design scheme described as an "example" in this application should not be explained as being more preferred or having more advantages than another embodiment or design scheme. Exactly, the term "example" is for presenting a concept in a specific manner.

The terms "include", "comprise", "have", and their variants all mean "include but are not limited to", unless otherwise specifically emphasized in another manner.

"At least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between associated objects. "At least one of the following items (pieces)" or a similar expression thereof indicates any combination of these items, including a single item (piece) or any combination of a plurality of items (pieces). For example, at least one of a, b, and c may indicate a, b, c, a and b, a and c, b and c, or a, b, and c. Each of a, b, and c may be in a singular form or a plural form.

In embodiments of this application, related descriptions about sending a message, information, or data by a network element A to a network element B, and receiving the message, the information, or the data by the network element B from the network element A are intended to describe a network element to which the message, the information, or the data is to be sent. Whether the message, the information, or the data is directly sent or indirectly sent through another network element is not limited.

In embodiments of this application, descriptions such as "when", "in a case", and "if" all mean that a device performs corresponding processing in a specific objective situation, but are not intended to limit time, do not require that the device has a determining action during implementation, and do not mean any other limitation.

The technical solutions in embodiments of this application are applicable to various communication systems, including but not limited to a 5th generation (5th generation, 5G) system or an NR system, an LTE system, a long term evolution-advanced (long term evolution-advanced, LTE-A) system, an LTE frequency division duplex (frequency division duplex, FDD) system, an LTE time division duplex (time division duplex, TDD) system, and the like. The technical solutions are further applicable to a future communication system, for example, a 6th generation mobile communication system. In addition, the technical solutions are further applicable to device to device (device to device, D2D) communication, vehicle-to-everything (vehicle-to-everything, V2X) communication, machine to machine (machine to machine, M2M) communication, machine type communication (machine type communication, MTC), an internet of things (internet of things, IoT) communication system, or another communication system. In addition, the technical solutions may be further extended to a similar wireless communication system, for example, a communication system related to wireless fidelity (wireless fidelity, Wi-Fi), worldwide interoperability for microwave access (worldwide interoperability for microwave access, WiMAX), and the 3rd generation partnership project (3rd generation partnership project, 3GPP). This is not limited.

The communication system applicable to this application may include one or more transmit ends and one or more receive ends. Optionally, one of the transmit end and the receive end may be a terminal, and the other may be a network device. Optionally, both the transmit end and the receive end may be terminals. Optionally, both the transmit end and the receive end may be network devices.

For example, FIG. 1 is a diagram of a communication scenario to which an embodiment of this application is applicable.

As shown in FIG. 1, this embodiment of this application is applicable to uplink data transmission and is also applicable to downlink data transmission. In FIG. 1, only uplink data transmission or downlink data transmission between one network device and two terminals (for example, a terminal 1 and a terminal 2) is used as an example. In uplink data transmission, the transmit end in this specification is a terminal, and the receive end is a network device. In downlink data transmission, the transmit end is a network device, and the receive end is a terminal. In addition, applicability of embodiments of this application in another communication scenario is not limited. For example, embodiments of this application may also be applied to sidelink communication.

The terminal in this application may also be referred to as user equipment (user equipment, UE), an access terminal, a subscriber unit, a subscriber station, a mobile station, a mobile terminal (mobile terminal, MT), a remote station, a remote terminal, a mobile device, a user terminal, a terminal device, an uncrewed aerial vehicle, a wireless communication device, a user agent, or a user apparatus. The terminal device in embodiments of this application may be a device that provides voice and/or data connectivity for a user, and may be configured to connect a person, an object, and a machine, for example, a handheld device or a vehicle-mounted device having a wireless connection function. The terminal device in embodiments of this application may be a mobile phone (mobile phone), a tablet computer (pad), a notebook computer, a palmtop computer, a mobile internet device (mobile internet device, MID), a wearable device, a virtual reality (virtual reality, VR) device, an augmented reality (augmented reality, AR) device, a wireless terminal in industrial control (industrial control), a wireless terminal in self-driving (self-driving), a wireless terminal in remote medical surgery (remote medical surgery), a wireless terminal in a smart grid (smart grid), a wireless terminal in transportation safety (transportation safety), a wireless terminal in a smart city (smart city), a wireless terminal in a smart home (smart home), or the like.

The network device in this application may be a device having a wireless transceiver function. The network device may be a device that provides a wireless communication function service, is usually located on a network side, and includes but is not limited to a next generation NodeB (gNodeB, gNB) in a 5G system, a base station in a 6th generation mobile communication system, a base station in a future mobile communication system, an access node in a wireless fidelity (wireless fidelity, Wi-Fi) system, an evolved NodeB (evolved NodeB, eNB) in a long term evolution (long term evolution, LTE) system, a radio network controller (radio network controller, RNC), a NodeB (NodeB, NB), a base station controller (base station controller, BSC), a home base station (for example, a home evolved NodeB, or a home NodeB, HNB), a baseband unit (baseband unit, BBU), a transmission reception point (transmission reception point, TRP), a transmission point (transmitting point, TP), a base transceiver station (base transceiver station, BTS), a satellite, an uncrewed aerial vehicle, and the like. In a network structure, the network device may include a central unit (central unit, CU) node or a distributed unit (distributed unit, DU) node; or may be a RAN device including a CU node and a DU node, or a RAN device including a CU-control plane node, a CU-user plane node, and a DU node. Alternatively, the network device may be a radio controller, a relay station, a vehicle-mounted device, a wearable device, and the like in a cloud radio access network (cloud radio access network, CRAN) scenario. In addition, the base station may be a macro base station, a micro base station, a relay node, a donor node, or a combination thereof. The base station may alternatively be a communication module, modem, or chip disposed in the foregoing device or apparatus. The base station may alternatively be a mobile switching center, a device that bears a base station function in D2D, V2X, and M2M communication, a network side device in a 6G network, a device that bears a base station function in a future communication system, or the like. The base station may support networks of a same access technology or different access technologies. This is not limited.

It should be noted that an apparatus configured to implement a function of the terminal or the network device in this application may be a terminal or a network device, or may be an apparatus, for example, a chip system or a chip, that can support the terminal or the network device in implementing the function. The apparatus may be mounted in the terminal or the network device. In embodiments of this application, the chip system may include a chip, or may include a chip and another discrete device.

It should be further noted that in some embodiments of this specification, a 5G system is used as an example to describe specific solution details. It may be understood that when the solution is applied to another communication system, for example, an LTE system or a future communication system, messages, channels, information, or the like in the solution may be replaced with messages, channels, information, or the like that can implement corresponding functions in the another communication system. This is not limited in this application.

For ease of understanding the solutions in this application, terms in this application are first described.

1. LDPC code

The LDPC code is a linear block code, and a check matrix of the LDPC code is a sparse matrix. In the check matrix of the LDPC code, a quantity of zero elements is far greater than a quantity of non-zero elements. Alternatively, a row weight and a column weight of the check matrix are much less than a code length of the LDPC code. An LDPC code whose information bit sequence length is equal to k and whose code length is equal to n may be uniquely determined based on a check matrix of the LDPC code.

In 1981, Tanner (Tanner) represented LDPC codewords in a graph. This graph now is referred to as a Tanner graph. The Tanner graph and a check matrix are in a one-to-one correspondence. The Tanner graph includes two types of vertices. One type of vertex indicates codeword bits and is referred to as a variable node. The other type of vertex is a check node and indicates a check constraint relationship. Each check node indicates one check constraint relationship. The following provides descriptions with reference to FIG. 2 and FIG. 3.

FIG. 2 is a diagram of a check matrix H of LDPC.

In FIG. 3, $\{V_i\}$ represents a variable node set, and $\{C_i\}$ represents a check node set. In the check matrix H, each row indicates one check equation, each check equation corresponds to one check node, each column indicates one codeword bit, and each codeword bit corresponds to one variable node. In FIG. 1, there are eight variable nodes and four check nodes. If a codeword bit is included in a corresponding check equation, a variable node and a check node that are used are connected by using a connection line, to obtain a Tanner graph.

FIG. 3 is a Tanner graph of a check matrix H of LDPC.

As shown in FIG. 3, the Tanner graph indicates the check matrix of the LDPC. For example, for the check matrix H with a size of m rows and n columns, the Tanner graph includes two types of nodes: n variable nodes and m check nodes. The n variable nodes respectively correspond to the n columns of the check matrix H, and the m check nodes respectively correspond to the m rows of the check matrix H. A cycle in the Tanner graph consists of connected vertices. The cycle uses one of the vertices as both a start point and an end point, and passes through each node only once. A length of the cycle is defined as a quantity of connection lines included in the cycle. A girth of a graph may also be referred to as a size of the graph, and is defined as a shortest cycle length in the graph. In FIG. 3, a girth is 6, as shown by a bold connection line in FIG. 3. The variable nodes in the Tanner graph each correspond to one column of the check matrix H, that is, correspond to each LDPC codeword bit. The check nodes in the Tanner graph each correspond to one row of the check matrix H, that is, correspond to LDPC parity bit. Whether there is a connection between the two types of nodes corresponds to a value of an element in the matrix H. If there is a connection between an $i^{th}$ check node and a $j^{th}$ variable node, it indicates that a value of an element (i, j) in the matrix H is 1. If there is no connection between them, the value of the element is 0. A connection line between a variable node and a check node may also be referred to as an edge. That there is a connection between a check node and a variable node may also be described as that there is a connection relationship between the check node and the variable node.

In addition, in the Tanner graph, a cycle (cycle) is a closed loop formed by variable nodes, check nodes, and edges connected end to end.

As described above, the LDPC code is a linear block code. In the linear block code, a to-be-encoded information sequence is divided into groups in a unit of k bits, and an encoder performs a linear operation on the k information bits to obtain m parity bits. Then, the k information bits are combined with the m parity bits to obtain a code group whose length is n = k + m. A mapping relationship between the k information bits and the code group whose length is n bits is usually represented by a corresponding check matrix H. An encoding sequence may be correspondingly generated based on the check matrix H to complete an encoding process. After the encoding sequence is transmitted through a channel, a receive end correspondingly decodes a received signal, to determine an original information bit.

2. QC-LDPC

A quasi-cyclic low-density parity-check (quasi-cyclic low-density parity-check, QC-LDPC) code is a type of structured LDPC code. Due to a unique structure of a check matrix of the QC-LDPC code, a simple feedback shift register may be used during encoding, to reduce LDPC encoding complexity. An LDPC code with a large code length has an extremely large check matrix H. Therefore, H is usually represented by blocks: The complete check matrix H is considered to be generated from a plurality of $Z_c \times Z_c$ submatrices. Specifically, the complete check matrix H may be represented by a base matrix $H_b$. Each element in $H_b$ corresponds to one $Z_c \times Z_c$ submatrix. Each submatrix may be represented by a quantity of cyclic shift bits. Therefore, storage space needed by the complete check matrix H is greatly reduced. An element in the base matrix $H_b$ may also be referred to as a quasi-cyclic (quasi-cyclic, QC) block.

Based on the base matrix $H_b$ and a lifting factor $Z_c$, the base matrix $H_b$ may be extended to the complete check matrix for encoding or decoding. $Z_c$ (lifting size) may also be referred to as a lifting factor, a lifting value, an extension value, an extension factor, a lifting size, or the like. "Lifting value" is used in this application.

For example, the base matrix $H_b$ of QC-LDPC is as follows:

$$\begin{bmatrix} 13 & 48 & 80 & 66 & 4 & 74 & 7 & 30 & 76 & 52 & 37 & 60 & -1 & 49 & -1 & 73 & 31 & 74 & 73 & 23 & 1 & 0 & -1 & -1 \\ 69 & 63 & 74 & 56 & 64 & 77 & 57 & 65 & 6 & 16 & 51 & -1 & 64 & -1 & 64 & 68 & 9 & 48 & 62 & 54 & -1 & 0 & 0 & -1 \\ 51 & 15 & 0 & 80 & 24 & 25 & 42 & 54 & 44 & 71 & 71 & 9 & 67 & 35 & 67 & -1 & 58 & -1 & 29 & -1 & 0 & -1 & 0 & 0 \\ 16 & 29 & 36 & 41 & 44 & 56 & 59 & 37 & 50 & 24 & -1 & 65 & 4 & 65 & 4 & 52 & -1 & 4 & -1 & 73 & 1 & -1 & -1 & 0 \end{bmatrix}$$

It can be learned that the base matrix $H_b$ has a size of 4 rows and 24 columns. Each element in the base matrix $H_b$ represents a square matrix with $Z_c$ = code length/24-order. An element $P_{Z_c}^{i}$ represents a circulant permutation matrix. i represents a cyclic shift value. $0 \le i \le Z_c - 1$. i is an integer. In addition, in the base matrix $H_b$, "-1" represents an all-zero matrix, and "0" represents an identity matrix.

For example, $P_{Z_c}^{1}$ is as follows:

$$P_{Z_c}^{1} = \begin{bmatrix} 0 & 1 & 0 & \ldots & 0 \\ 0 & 0 & 1 & \ldots & 0 \\ \vdots & \vdots & \vdots & \ddots & \vdots \\ 0 & 0 & 0 & \ldots & 1 \\ 1 & 0 & 0 & \ldots & 0 \end{bmatrix}$$

It should be noted that a zero element in the base matrix $H_b$ may alternatively be represented in a form other than "-1". For example, "-" or a null value is used to represent an all-zero matrix.

3. Basic structure of a base matrix

A 5th generation (5th generation, 5G) NR LDPC code is used as an example. The 5G NR LDPC code uses a "Raptor-like (Raptor-like)" structure. Its parity-check matrix may be gradually extended to a low code rate by using a core matrix (Kernel Matrix) with a high code rate. In this way, encoding at various code rates can be flexibly supported.

FIG. 4 is a diagram of a structure of a parity-check matrix of 5G NR LDPC. As shown in FIG. 4, the parity-check matrix of 5G NR LDPC includes five parts: A, B, C, D, and E. A and B jointly form a high-code-rate core matrix, A corresponds to information bits (or referred to as information bits), and B is a square matrix and corresponds to high-code-rate parity bits (or referred to as parity bits). C is an all-zero matrix. E is an identity matrix and corresponds to a parity bit with a low extended code rate. D and E jointly form a single parity check relationship.

4. IR-HARQ

In an incremental redundancy-hybrid automatic repeat request (incremental redundancy-hybrid automatic repeat request, IR-HARQ) mechanism, a transmit end sends information bits and some redundant bits during initial transmission, and sends additional redundant bits during retransmission. If decoding fails during the initial transmission, the transmit end retransmits more redundant bits, to decrease a code rate of a channel, so as to increase a decoding success rate. If the receive end still cannot correctly perform decoding based on redundant bits in a first retransmission, the transmit end performs retransmission again. As a quantity of retransmissions increases, redundant bits continuously increase, and a channel coding rate is continuously decreased, to achieve better decoding effects.

The IR HARQ mechanism requires an LDPC encoding scheme compatible with a plurality of rates, so that a new incremental redundant bit can be introduced during retransmission.

4. 5G NR LDPC code

A check matrix of the 5G NR LDPC code includes the following main features:

(1) Large column weight and puncturing design

The feature means that the check matrix of the 5G NR LDPC code has variable nodes with very large degrees. After encoding is completed, a transmit end may puncture columns corresponding to the variable nodes. In other words, the transmit end does not send the encoded columns corresponding to the variable nodes, and a receive end device sets log likelihood ratios (log likelihood ratios, LLRs) corresponding to the punctured columns to 0 for decoding.

(2) Raptor-like extended node structure design

The feature means that an extended node of a check matrix of the 5G NR LDPC code has a single diagonal structure, to be specific, a degree of the extended node is 1, and the extended node appears only in one check equation.

(3) QC block structure

The feature means that an actually used LDPC code is to extend a non-negative element in the base matrix $H_b$ to a cyclic shift matrix by using a lifting value $Z_c$.

(4) Dense core region (core region)

The check matrix of the 5G NR LDPC code has dense connections in 1$^{st}$ to 4$^{th}$ rows and 1$^{st}$ to 26$^{th}$ columns (relative to other positions). This part is referred to as a core matrix (Kernel Matrix). The core matrix has a high edge density, and a degree of a parity bit is not 1. Each parity bit of a non-core matrix is a Raptor-like node, and has a degree of 1.

The 5G NR LDPC code supports IR-HARQ. However, a high-code-rate part (namely, the core matrix) of the 5G NR LDPC code can support only parallel decoding of QC blocks and cannot support parallel decoding of whole rows. In addition, a low-code-rate part supports parallel decoding of whole rows. Consequently, computing units of the high- and low-code-rate parts may be unable to be balanced. For example, to support parallel decoding of QC blocks of the high-code-rate-part, many computing units are disposed for each row. When decoding is performed for the low-code-rate part, only parts of the computing units may be used, resulting in a large area waste of the computing units. In addition, a peak throughput of the 5G NR LDPC code cannot reach 100 Gbps, and a decoding latency is long. The 5G NR LDPC code has good ultimate performance, but its puncturing design causes slow convergence. To achieve the ultimate performance, a large quantity of iterations are needed, and there are a large quantity of equivalent decoded rows in an iteration.

5. 802.11ay LDPC code

A check matrix of the 802.11ay LDPC code includes the following main features:

(1) A check matrix is stored for each code rate, and there are only several specific code rates and code lengths. Flexible code rates and code lengths are not supported, a nesting feature is not supported, and IR-HARQ is not supported.

(2) A low-code-rate check matrix is multi-row orthogonal, and row parallel decoding may be performed.

(3) A QC block structure is the same as that of the 5G NR LDPC code.

(4) A high-code-rate check matrix has a high edge density, and the low-code-rate check matrix has a low edge density. An overall edge density is high from the perspective of all check matrices. The 802.11ay LDPC code has a large limitation on a code rate, matrix storage is redundant, flexibility is poor, different code rates do not have a nesting property, and IR-HARQ is not supported. Ultimate performance and a decoding threshold of the 802.11ay LDPC code are bad.

6. Non-zero element and zero element

In this application, a zero element in a check matrix indicates that there is no connection between a variable node and a check node. A non-zero element in a check matrix indicates that there is a connection between a variable node and a check node.

Specific representation forms of the zero element and the non-zero element are not limited in this application. For example, in a base matrix $H_b$, a zero element may be represented by "-1" and a non-zero element may be represented by a "non-negative value". For another example, in a check matrix H, "0" may represent a zero element, and "1 " may represent a non-zero element.

7. Column weight and row weight

For a column of a matrix, the column weight may be a quantity of "1"s included in the column. For a row of the matrix, the row weight may be a quantity of "1"s included in the row. The column weight may also be referred to as a column degree. For a check matrix, the column weight may also be referred to as a degree of a variable node.

8. Extended column, non-extended column, extended row, and non-extended row

For an LDPC code, each time one extended node is added, one row and one column are added. In this application, the added row and column are referred to as an extended column and an extended row. The extended column is a column corresponding to the extended node. In other words, the extended column corresponds to an extended parity bit. A column other than the extended column is a non-extended column. A row other than the extended row is a non-extended row. For example, in FIG. 4, columns in C and E are extended columns, and rows in D and E are extended rows.

In addition, in this application, a part formed by non-extended columns may also be referred to as a core part, and a part formed by extended columns may also be referred to as an extended part. For example, in FIG. 4, a part formed by A, B, and D is a core part, and a part formed by C and E is an extended part.

9. Information transmission procedure

FIG. 5 is a diagram of an information transmission procedure. As shown in FIG. 5, information is sent by a source, and after processing such as source encoding, channel encoding, modulation, air interface transmission, demodulation, channel decoding, and source recovery, the information reaches a sink, so that transmission of the information from the source to the sink is completed. In FIG. 5, processing (including source encoding, channel encoding, modulation, and the like) shown at an upper layer is performed at a transmit end, and processing (including demodulation, channel decoding, source recovery, and the like) shown at a lower layer is performed at the transmit end. Embodiments of this application mainly relate to source encoding, channel encoding, channel decoding, and source recovery shown in FIG. 5.

This application is intended to provide an LDPC code with better performance. The following describes the technical solutions of this application with reference to the accompanying drawings. FIG. 6 is a schematic flowchart of an LDPC code-based communication method 600 according to this application.

The method 600 may be performed by a transmit end, or a module or unit in the transmit end, hereinafter collectively referred to as the transmit end for ease of description. The method 600 may include at least a part of the following content.

Step 601: The transmit end obtains an information bit sequence.

To be specific, if the transmit end needs to communicate with a receive end, in other words, the transmit end needs to send a signal to the receive end, the transmit end needs to first obtain an information bit sequence corresponding to the signal that needs to be sent to the receive end.

Optionally, that the transmit end obtains the to-be-sent information sequence may mean that the transmit end performs source encoding on a source symbol to generate the information bit sequence. Alternatively, that the transmit end obtains the to-be-sent information sequence may mean that the transmit end receives the information bit sequence from another communication apparatus.

Step 602: The transmit end performs LDPC encoding on the information bit sequence based on an LDPC base matrix to obtain an LDPC coding bit sequence.

The LDPC base matrix may be obtained based on a storage matrix and indication information. The LDPC base matrix may be a matrix actually used by the transmit end. The storage matrix may be a matrix stored in the transmit end or a matrix predefined in a protocol.

In a process of obtaining the LDPC base matrix, low-code-rate extension includes two manners, as shown in FIG. 7.

One is conventional low-code-rate extension. In this manner, a row of the storage matrix is directly read as a row of the LDPC base matrix. For ease of description, this extension manner is referred to as conventional extension below. The other is split low-code-rate extension based on Patent Application No. PCT/CN2022/132833 filed on November 18, 2022 and entitled "LDPC CODE-BASED COMMUNICATION METHOD AND COMMUNICATION APPARATUS". For ease of description, this extension manner is referred to as split extension below.

Split extension differs from conventional extension in that when a row of the storage matrix is read as a newly added row of the LDPC base matrix, the newly added row further needs to be used to perform elimination on a row before the newly added row in the LDPC base matrix, and parts other than an extended node in a row obtained after the elimination and the newly added row are orthogonal. This may also be understood as that the row on which the elimination is performed is split into the newly added row and the row obtained after the elimination. Split extension does not change a column weight of a non-extended column.

Conventional extension can increase an overall edge density of the LDPC base matrix, whereas split extension can reduce the overall edge density of the LDPC base matrix.

Whether each extension is conventional extension or split extension may be determined by the indication information.

In this way, in a process of obtaining the LDPC base matrix through low-code-rate extension, in comparison with a process in which only one low-code-rate extension manner is used, low-code-rate extension in this application is more flexible, to help obtain an LDPC base matrix with better performance.

In a possible implementation, the indication information includes first information and second information.

(1) The first information corresponds to split extension. In a possible implementation, the first information indicates one or more row pairs. Each of the one or more row pairs corresponds to two rows of the storage matrix. One row pair is used for description. A shifting value (shifting value) of a non-zero element in a first row in a row pair corresponds to a shifting value of a non-zero element in a second row in the row pair.

Optionally, that the shifting value of the non-zero element in the first row in the row pair corresponds to the shifting value of the non-zero element in the second row in the row pair may be that shifting values of non-zero elements other than an extended node in the first row are properly included in shifting values of non-zero elements other than an extended node in the second row. This may also be understood as that connection relationships, edges, or the non-zero elements other than the extended node in the first row are properly included in connection relationships, edges, or the non-zero elements other than the extended node in the second row, and the shifting value of the non-zero element other than the extended node in the first row is the same as the shifting value of the non-zero element at a corresponding position in the second row.

For example, the first row is {1, -1, -1, 3, -1, 5, -1, -1, 1, -1} and the second row is {1, -1, 2, 3, 4, 5, -1, 1, -1, -1}. The last three elements correspond to extended nodes. -1 represents a zero element. {1, -1, -1, 3, -1, 5, -1} is properly included in {1, -1, 2, 3, 4, 5, -1}.

Optionally, that the shifting value of the non-zero element in the first row in the row pair corresponds to the shifting value of the non-zero element in the second row in the row pair may alternatively be that sums of a fixed value and shifting values of non-zero elements other than an extended node in the first row are properly included in shifting values of non-zero elements other than an extended node in the second row. This may also be understood as that connection relationships, edges, or the non-zero elements other than the extended node in the first row are properly included in connection relationships, edges, or the non-zero elements other than the extended node in the second row, and the shifting value of the non-zero element other than the extended node in the first row differs from the shifting value of the non-zero element at a corresponding position in the second row by the fixed value.

For example, the first row is {2, -1, -1, 4, -1, 6, -1, -1, 1, -1} and the second row is {1, -1, 2, 3, 4, 5, -1, 1, -1, -1}. The last three elements correspond to extended nodes. -1 represents a zero element. Non-zero elements in {2, -1, -1, 4, -1, 6, -1} are properly included in {1, -1, 2, 3, 4, 5, -1}. However, the shifting value of the non-zero element in the first row differs from the shifting value of the non-zero element at a corresponding position in the second row by 1.

A row that is of the LDPC base matrix and that corresponds to the first row of the storage matrix is the same as the first row of the storage matrix. In other words, the row that is of the LDPC base matrix and that corresponds to the first row of the storage matrix is obtained by directly reading the first row of the storage matrix.

A row that is of the LDPC base matrix and that corresponds to the second row of the storage matrix is obtained by performing elimination on the second row of the storage matrix with the first row of the storage matrix. It should be noted that elimination herein may be performed one or more times. For example, the row pairs indicated by the first information include row pairs (5, 2) and (8, 2) of a row #2. For (5, 2), a row that is of the LDPC base matrix and that corresponds to a row #5 is obtained by performing elimination once on the row #2 of the storage matrix with the row #5 of the storage matrix. For (8, 2), a row that is of the LDPC base matrix and that corresponds to a row #8 is obtained by performing elimination twice on the row #2 of the storage matrix with the row #8 of the storage matrix, that is, performing elimination on the row #2 of the storage matrix with the row #5 of the storage matrix and performing elimination with the row #8 of the storage matrix on a row obtained after the elimination is performed on the row #2 with the row #5.

Alternatively, that the row that is of the LDPC base matrix and that corresponds to the second row of the storage matrix is obtained by performing elimination on the second row of the storage matrix with the first row of the storage matrix may be described as that the row that is of the LDPC base matrix and that corresponds to the second row is obtained by performing elimination on the second row of the LDPC base matrix before current extension with the first row of the storage matrix. Because the row that is of the LDPC base matrix and that corresponds to the first row is the same as the first row of the storage matrix, this may also be described as that the row that is of the LDPC base matrix and that corresponds to the second row is obtained by performing elimination on the second row of the LDPC base matrix before the current extension with the row that is of the LDPC base matrix and that corresponds to the first row of the storage matrix.

(2) The second information corresponds to conventional extension. In a possible implementation, the second information indicates one or more third rows. The one or more third rows of the LDPC base matrix are the same as the one or more third rows of the storage matrix. The one or more third rows indicated by the second information may be rows of the storage matrix or rows of the LDPC base matrix. This is not limited.

That the one or more third rows of the LDPC base matrix are the same as the one or more third rows of the storage matrix may be understood as that a connection relationship, an edge, or a non-zero element in the one or more third rows of the LDPC base matrix is the same as a connection relationship, an edge, or a non-zero element in the one or more third rows of the storage matrix, and a shifting value of the non-zero element in the one or more third rows of the LDPC base matrix is the same as a shifting value of the non-zero element in the one or more third rows of the storage matrix.

For example, if the second information indicates a row #6 and a row #9, a connection relationship and a shifting value of the row #6 of the LDPC base matrix are the same as those of the row #6 of the storage matrix, and a connection relationship and a shifting value of the row #9 of the LDPC base matrix are the same as those of the row #9 of the storage matrix.

Step 603: The transmit end sends the LDPC coding bit sequence to the receive end.

Therefore, in the method 600, the overall edge density of the LDPC base matrix can be increased through conventional extension and reduced through split extension. This helps maintain an optimal edge density of the LDPC base matrix during low-code-rate extension, to improve performance of the LDPC code. In addition, the method 600 supports flexible code rates and thus supports an IR-HARQ mechanism.

The following describes in detail the indication information in embodiments of this application.

A specific form of the indication information is not limited in this application. For example, a form used for the indication information may include at least one of an indication sequence, a mapping table, or a mapping pair.

The following describes the indication information by using an example in which the indication information is in a form of an indication sequence.

In a possible implementation, a length of the indication sequence is equal to a quantity of rows of the LDPC base matrix. A position of an element of the indication sequence in the indication sequence corresponds to a row number of the first row or a row number of the third row. A value of the element of the indication sequence indicates split extension or conventional extension. For example, the indication information includes one or more row numbers and one or more first characters. If a value of an element at a position is a row number, it indicates split extension. If a value of an element at a position is a first character, it indicates conventional extension.

Specifically, the first information includes a row number of a second row in each of the one or more row pairs. A row number of a first row in the row pair is a position of the row number of the second row in the row pair in the indication sequence. The second information includes one or more first characters. Positions of the one or more first characters in the indication sequence correspond to row numbers of the one or more third rows. It may be understood that the position of the row number of the second row in the row pair in the indication sequence is greater than the row number of the first row in the row pair.

For example, it is assumed that an initial matrix (or referred to as a core matrix of the LDPC base matrix, an initial base matrix, or a core matrix of the storage matrix) has M rows, and the indication sequence is described as follows:

(1) Content of the indication sequence: Elements in the indication sequence include a first character and a row number whose value is less than a current position.
(2) Length of the indication sequence: The length is the quantity of rows of the LDPC base matrix, or may be described as a total quantity of check nodes of the LDPC base matrix generated through low-code-rate extension.
(3) Order of the elements in the indication sequence: For a position after an $M^{th}$ position, the order of the elements is an extension order. An $i^{th}$ position of the indication sequence corresponds to an $i^{th}$ row of the storage matrix. i is a positive integer.
(4) Values of the elements in the indication sequence: Values at first $M$ positions correspond to row numbers of the initial matrix and do not include a first character. Alternatively, the first $M$ positions are all first characters, that is, the first $M$ positions are regarded as conventional extension. If a position after the $M^{th}$ position is a first character, it corresponds to conventional extension. If the position is not a first character, the position corresponds to a row number of a row on which elimination (or splitting) is performed during current split extension.
(5) Quantity of values of a type in the indication sequence: A quantity of row numbers included at positions after the $M^{th}$ position is a quantity of times split extension is performed, namely, a quantity of extended nodes included in the current LDPC base matrix. A quantity of first characters is a quantity of times conventional extension is performed.

Optionally, the first character is a special character. For example, the first character may be a value other than a row number of the storage matrix.

Optionally, the indication sequence or the second information includes a plurality of first characters. The plurality of first characters include at least two types of values. In other words, a plurality of first characters may be set.

Optionally, third rows of the storage matrix that correspond to first characters with a same value are pairwise orthogonal.

In a possible implementation, the indication sequence is obtained by optimizing a decoding threshold. In this way, the indication sequence has an obvious segmentation feature.

For example, the indication sequence sequentially includes a first segment, a second segment, a third segment, and a fourth segment. The first segment corresponds to the core matrix of the storage matrix. The first segment consists of one or more first row numbers or one or more second characters. The second segment consists of one or more third characters. The third segment consists of one or more second row numbers. The fourth segment is formed by interleaving one or more fourth characters and one or more third row numbers. The row number in the first information sequentially includes the one or more first row numbers, the one or more second row numbers, and the one or more third row numbers. The one or more first characters (or second information) sequentially include the one or more second characters, the one or more third characters, and the one or more fourth characters.

It should be noted that "sequentially including" may be understood as including with included content adjacent to each other without intersection. For example, that the indication sequence sequentially includes the first segment, the second segment, the third segment, and the fourth segment may be understood as that the indication sequence includes the first segment, the second segment, the third segment, and the fourth segment, the four segments are sequentially adjacent, and there is no intersection between two adjacent segments.

Optionally, when the first segment consists of the one or more first row numbers, the one or more second row numbers include at least one or all of the one or more first row numbers.

Optionally, the one or more third row numbers include at least one or all of row numbers of third rows corresponding to the one or more fourth characters.

Optionally, a proportion of the fourth characters in the fourth segment increases as a code rate corresponding to the LDPC base matrix decreases.

The following provides a general form of the indication sequence.

The first character is denoted as α. A quantity of rows of the core matrix is denoted as M. The indication sequence may be represented as follows:

$$\theta = \begin{cases} 1, \ldots, M \\ \alpha_{1\times T} \\ p_1(1, \ldots, M+T), p_2(1, \ldots, 2M+2T) \ldots \\ \gamma(\alpha, p_x) \end{cases}$$

It can be learned that the indication sequence is a four-segment piecewise function. The first segment 1, ... , *M* is a core segment, and corresponds to the core matrix (or a core check equation) of the storage matrix. The second segment $\alpha_{1\times T}$ is a conventional extension segment, and corresponds to conventional extension (or a conventional extension check equation). The second segment consists of a first character. The third segment $p_1(1, ..., M+T), p_2(1, ..., 2M+2T) ...$ is a split extension segment, corresponds to split extension, and consists of a row number (this segment definitely includes a row number of the core matrix). The fourth segment $\gamma(\alpha, p_x)$ is a hybrid segment of split extension and conventional extension. The fourth segment indicates that a first character is interleaved with a row number that appears before. T is a quantity of splitting rounds. The quantity of splitting rounds is a maximum quantity of splitting times of all check nodes. A quantity of splitting times of a check node includes a total quantity of splitting times of the check node and a check node obtained by splitting the check node. The check node obtained by splitting the check node includes a check node directly or indirectly obtained by splitting the check node. For example, if a check node #3 is split to generate check nodes #5 and #9, the check node #5 is split to generate a check node #7, and the check node #7 is split to generate a check node #19, the check nodes #5 and #9 are check nodes directly obtained by splitting the check node #3, the check nodes #7 and #19 are check nodes indirectly obtained by splitting the check node #3, a quantity of splitting times of the check node #3 is 4, a quantity of splitting times of the check node #5 is 2, a quantity of splitting times of the check node #7 is 1, and quantities of splitting times of the check nodes #9 and #19 are 0.

For example, an indication sequence for NR BG1 may be as follows: a core segment 0 1 2 3 4 5; a conventional extension segment α α α; a split extension segment 1 4 5 3 2 0 8 6 14 1 12 13 11 0 7; and a hybrid segment α 5 9 3 α 2 α 4 3 2 10 α 14 α α.

For another example, an indication sequence for NR BG2 may be as follows: a core segment 0 1 2 3; a conventional extension segment α α α α α α α; a split extension segment 2 3 0 1; and a hybrid segment α α 6 α 12 α α 18 1 α 24 α 26 20 α 29 α 31 α α 34 α 6.

It should be noted that the indication sequence is merely a representation form of the indication information, and essentially describes a binary mapping relationship between rows, indicating that there is a correlation between the rows. For example, a relationship between connection relationships and between shifting values mentioned in the foregoing description of the first information may alternatively be in another representation form, for example, the mapping table or the mapping pair mentioned above.

It can be learned from a meaning of an element value in the indication sequence that there may be no correlation between a row corresponding to a first character and another row. In a possible implementation, the one or more first characters in the indication sequence indicate only an extension manner (for example, conventional extension) of rows corresponding to the one or more first characters. Optionally, the one or more first characters have a same value. In a possible implementation, when the one or more first characters in the indication sequence indicate the extension manner (for example, conventional extension) of the rows corresponding to the one or more first characters, it may further indicate that there may be a correlation between the rows. For example, their connection relationships, edges, or non-zero elements are orthogonal to each other. Optionally, a plurality of first characters may be set in the indication sequence, or in other words, the first characters have various values, to indicate a correlation of a check equation generated through conventional extension. For example, connection relationships of rows in the storage matrix that correspond to first characters with a same value are orthogonal to each other.

In addition, it should be noted that if the indication information does not include the first information, it is equivalent to that the LDPC code provided in embodiments of this application falls back to a conventional LDPC code, for example, an NR LDPC code. If the indication information does not include the second information, it is equivalent to that the LDPC code provided in embodiments of this application falls back to an LDPC code described in Patent Application No. PCT/CN2022/132833 filed on November 18, 2022 and entitled "LDPC CODE-BASED COMMUNICATION METHOD AND COMMUNICATION APPARATUS".

The following describes in detail the storage matrix and the LDPC base matrix in this application.

(1) Storage matrix

In embodiments of this application, a matrix with a minimum code rate is stored. In other words, the storage matrix is the matrix with the minimum code rate.

A storage manner of the storage matrix is not limited in embodiments of this application.

In a possible implementation, the storage matrix is obtained based on a first table, a second table, and a third table. The first table includes all connection relationships of the storage matrix. The connection relationship is a connection relationship between a variable node and a check node. The second table includes a shifting value of a non-zero element in the core matrix of the storage matrix. The third table includes a shifting value of a non-zero element in the one or more third rows. In other words, an incomplete storage matrix is stored. Specifically, all connection relationships of the storage matrix and shifting values of the core matrix and a non-extended column in the one or more third rows in the storage matrix are stored. A row in which these shifting values are located may correspond to the core segment of the indication sequence and one or more first characters.

In the foregoing implementation, content stored in the transmit end includes the indication sequence, the first table, the second table, and the third table.

In this case, optionally, the transmit end may directly read the first table, the second table, and the third table based on the indication sequence, to generate the LDPC base matrix, and then encode the information bit sequence. In another way of understanding, the transmit end performs only conventional extension, but a shifting value of a non-zero element in a first row in a row pair is read from a second row in the row pair.

Optionally, the transmit end may read the first table, the second table, and the third table based on the indication sequence, and perform both split extension and conventional extension based on the indication sequence, to generate the LDPC base matrix, and then encode the information bit sequence. That is, for a row pair indicated by the indication sequence, a shifting value of a non-zero element in a first row is read from a second row in the row pair, and elimination is simultaneously performed.

The following provides an example of this implementation.

(a) Indication sequence: 60 60 60 60 60 60 60 60 60 1 4 5 3 2 0 8 6 14 1 12 13 11 0 7 10 5 3 9 2 4 60 1260 13 60 1460 10986060760 11 6053 6260022 18 1 60 16 15 6050.

A value of the first character is 60.

(b) The first table is shown in Table 1.

Table 1

| | | $H_{BG}$ | | $H_{BG}$ | | $H_{BG}$ | | $H_{BG}$ | | $H_{BG}$ | |
|---|---|---|---|---|---|---|---|---|---|---|---|
| Row index | Column index | Row index | Column index | Row index | Column index | Row index | Column index | Row index | Column index | Row index | Column index |
| | 0 | | 0 | | 2 | | 0 | | 2 | | 6 |
| | 1 | | 2 | | 3 | | 3 | | 10 | 37 | 14 |
| | 2 | | 3 | | 5 | | 6 | | 11 | | 27 |
| | 3 | 3 | 4 | 6 | 10 | 12 | 8 | 21 | 17 | | 70 |
| | 5 | | 5 | | 13 | | 12 | | 33 | | 2 |
| 0 | 6 | | 6 | | 14 | | 13 | | 54 | 38 | 9 |
| | 7 | | 8 | | 16 | | 15 | | | | 26 |
| | 8 | | 9 | | 17 | | 16 | | | | 71 |
| | 9 | | 10 | | 18 | | 25 | | | | 1 |
| | 11 | | 12 | | 20 | | 29 | | 0 | 39 | 12 |
| | 12 | | 13 | | 21 | | 37 | | 9 | | 33 |
| | 14 | | 15 | | 28 | | 45 | | 12 | | 72 |
| | 15 | | 16 | | 39 | | | 22 | 20 | | 1 |
| | 17 | | 18 | | | | | | 24 | | 16 |
| | 18 | | 19 | | | | | | 27 | 40 | 22 |
| | 20 | | 21 | | | | | | 55 | | 34 |
| | 22 | | 23 | | | | | | | | 35 |
| | 24 | | 25 | | | | | | | | 73 |
| | 27 | | 29 | | | | | | | | 4 |
| | 29 | | 31 | | | | | | | | 5 |
| | 32 | | 33 | | | | | | 2 | 41 | 7 |
| | 35 | | 37 | | 2 | | 1 | | 10 | | 24 |
| | 38 | | | | 3 | | 2 | | 16 | | 27 |
| | | | | | 5 | | 5 | 23 | 17 | | 74 |
| | | | | | 10 | | 7 | | 23 | | 5 |
| | | | | | | | | | 56 | | 13 |
| | | | | | 13 | | 9 | | | 42 | 18 |
| | | | | | 14 | | 13 | | | | |
| | | | | 7 | 16 | | 16 | | | | 75 |
| | | | | | 17 | 13 | 20 | | | | 0 |
| | | | | | | | | | | | 3 |
| | | | | | 18 | | 26 | | 0 | | 9 |
| | | | | | 21 | | 28 | | 4 | 43 | 14 |
| | | | | | 23 | | 35 | 24 | 9 | | 17 |
| | | | | | 40 | | 46 | | 23 | | |
| | | | | | | | | | 30 | | 76 |
| | | | | | | | | | 57 | | 1 |
| | | | | | | | | | | 44 | 7 |
| | | | | | | | | | | | 25 |
| | | | | | | | | | | | 77 |
| | | | | | | | | | | | 11 |
| | | | | | | | | | 0 | | 26 |
| | | | | | 1 | | 1 | | 8 | 45 | 28 |
| | 0 | | 0 | | 2 | | 2 | | 21 | | 29 |
| | 1 | | 1 | | 4 | | 3 | 25 | 23 | | 78 |

(continued)

| | | $H_{BG}$ | | $H_{BG}$ | | $H_{BG}$ | | $H_{BG}$ | | $H_{BG}$ | |
|---|---|---|---|---|---|---|---|---|---|---|---|
| Row index | Column index | Row index | Column index | Row index | Column index | Row index | Column index | Row index | Column index | Row index | Column index |
| 1 | 2, 3, 4, 6, 7, 8, 9, 11, 12, 14, 15, 17, 18, 20, 22, 24, 26, 28, 31, 34, 38 | 4 | 3, 4, 5, 6, 7, 9, 10, 11, 13, 14, 16, 17, 19, 21, 23, 25, 27, 30, 34, 36 | 8 | 9, 10, 12, 13, 16, 22, 23, 32, 33, 41 | 14 | 5, 6, 7, 8, 14, 17, 22, 29, 47 | | 36, 58 | 46 | 5, 14, 32, 79 |
| 2 | 1, 2, 3, 4, 5, 7, 8, 9, 10, 12 | 5 | 0, 1, 2, 4, 5, 6, 7, 8, 10, 11 | 9 | 1, 2, 3, 7, 9, 11, 12, 17, 18, 26, 34, 42 | 15 | 2, 4, 9, 13, 22, 32, 48 | 26 | 4, 10, 18, 21, 33, 59 | 47 | 5, 9, 19, 80 |
| | | | | 10 | 0, 1, 4, 6, 7, 9 | 16 | 2, 10, 13, 18, 21, 28, 49 | 27 | 1, 7, 12, 17, 34, 60 | 48 | 3, 16, 20, 81 |
| | | | | | | 17 | 1, 5, 7, 22, 29, 50 | 28 | 4, 8, 12, 15, 22, 61 | 49 | 3, 18, 37, 82 |
| | | | | | | | | 29 | 3, 10, 16, 19, 25, 62 | 50 | 8, 16, 26, 27, 29, 83 |
| | | | | | | | | 30 | 16, 18, 28, 38, 63 | 51 | 15, 18, 32, 84 |
| | | | | | | | | | | 52 | 0, 20, 27, 85 |
| | | | | | | | | | | 53 | 8, 24, 31, 86 |
| | | | | | | | | | | 54 | 4, 20, 28, 87 |

(continued)

<table>
<tr><th colspan="2"></th><th colspan="2">$H_{BG}$</th><th colspan="2">$H_{BG}$</th><th colspan="2">$H_{BG}$</th><th colspan="2">$H_{BG}$</th><th colspan="2">$H_{BG}$</th></tr>
<tr><th>Row index</th><th>Column index</th><th>Row index</th><th>Column index</th><th>Row index</th><th>Column index</th><th>Row index</th><th>Column index</th><th>Row index</th><th>Column index</th><th>Row index</th><th>Column index</th></tr>
<tr><td rowspan="11"></td><td rowspan="11">13<br>15<br>16<br>18<br>20<br>22<br>24<br>26<br>28<br>30<br>35<br>37</td><td rowspan="11"></td><td rowspan="11">13<br>14<br>16<br>17<br>19<br>21<br>23<br>25<br>26<br>32<br>33<br>36</td><td rowspan="2"></td><td rowspan="2">14<br>23<br>27<br>30<br>34<br>43</td><td rowspan="2">18</td><td rowspan="2">0<br>8<br>14<br>24<br>31<br>38<br>51</td><td>31</td><td>6<br>8<br>25<br>64</td><td>55</td><td>6<br>9<br>30<br>31<br>88</td></tr>
<tr><td>32</td><td>2<br>10<br>12<br>31<br>37<br>65</td><td>56</td><td>10<br>18<br>21<br>89</td></tr>
<tr><td rowspan="9">11</td><td rowspan="9">1<br>2<br>4<br>7<br>10<br>11<br>13<br>17<br>19<br>25<br>33<br>44</td><td rowspan="7">19</td><td rowspan="7">3<br>12<br>13<br>16<br>37<br>52</td><td>33</td><td>1<br>13<br>28<br>66</td><td>57</td><td>2<br>9<br>32<br>90</td></tr>
<tr><td rowspan="6">34</td><td rowspan="6">3<br>15<br>22<br>26</td><td rowspan="6"></td><td>4</td></tr>
<tr><td>13</td></tr>
<tr><td>21</td></tr>
<tr><td>36</td></tr>
<tr><td>38</td></tr>
<tr><td>91</td></tr>
<tr><td rowspan="2">20</td><td rowspan="2">2<br>7<br>9<br>26<br>35<br>53</td><td>35</td><td>3<br>8<br>14<br>68</td><td>59</td><td>8<br>26<br>92</td></tr>
<tr><td>36</td><td>0<br>8<br>20<br>21<br>23<br>69</td><td></td><td></td></tr>
</table>

The row index (Row Index) may also be referred to as a row number. The column index (Column Index) may also be referred to as a column number.

(c) The second table is shown in Table 2.

Table 2

| **H**$_{BG}$ | $V_{i,j}$ | | | | | | | | **H**$_{BG}$ | $V_{i,j}$ | | | | | | | |
|---|---|---|---|---|---|---|---|---|---|---|---|---|---|---|---|---|---|
| Row index *i* | Lifting value set index $i_{LS}$ | | | | | | | | Row index *i* | Lifting value set index $i_{LS}$ | | | | | | | |
| | 0 | 1 | 2 | 3 | 4 | 5 | 6 | 7 | | 0 | 1 | 2 | 3 | 4 | 5 | 6 | 7 |
| 0 | 0 | 0 | 0 | 0 | 0 | 0 | 0 | 0 | 3 | 7 | 2 | 0 | 0 | 6 | 16 | 4 | 9 |
| | 0 | 0 | 0 | 0 | 0 | 0 | 0 | 0 | | 91 | 0 | 61 | 88 | 130 | 190 | 110 | 109 |
| | 0 | 0 | 0 | 0 | 0 | 0 | 0 | 0 | | 82 | 251 | 262 | 207 | 244 | 13 | 206 | 61 |
| | 0 | 0 | 0 | 0 | 0 | 0 | 0 | 0 | | 101 | 371 | 239 | 214 | 78 | 187 | 141 | 63 |
| | 0 | 0 | 0 | 0 | 0 | 0 | 0 | 0 | | 32 | 343 | 304 | 212 | 183 | 230 | 178 | 0 |
| | 0 | 0 | 0 | 0 | 0 | 0 | 0 | 0 | | 124 | 375 | 215 | 209 | 20 | 323 | 5 | 17 |
| | 0 | 0 | 0 | 0 | 0 | 0 | 0 | 0 | | 154 | 341 | 166 | 183 | 106 | 232 | 167 | 164 |
| | 0 | 0 | 0 | 0 | 0 | 0 | 0 | 0 | | 61 | 256 | 3 | 68 | 275 | 204 | 68 | 3 |
| | 0 | 0 | 0 | 0 | 0 | 0 | 0 | 0 | | 125 | 271 | 294 | 208 | 115 | 123 | 25 | 98 |
| | 0 | 0 | 0 | 0 | 0 | 0 | 0 | 0 | | 81 | 308 | 105 | 185 | 225 | 41 | 9 | 25 |
| | 0 | 0 | 0 | 0 | 0 | 0 | 0 | 0 | | 46 | 262 | 32 | 72 | 11 | 244 | 81 | 97 |
| | 0 | 0 | 0 | 0 | 0 | 0 | 0 | 0 | | 88 | 311 | 236 | 90 | 246 | 20 | 3 | 95 |
| | 0 | 0 | 0 | 0 | 0 | 0 | 0 | 0 | | 11 | 368 | 318 | 141 | 216 | 217 | 136 | 221 |
| | 0 | 0 | 0 | 0 | 0 | 0 | 0 | 0 | | 254 | 374 | 289 | 178 | 205 | 198 | 150 | 86 |
| | 0 | 0 | 0 | 0 | 0 | 0 | 0 | 0 | | 0 | 0 | 0 | 0 | 0 | 0 | 0 | 0 |
| | 0 | 0 | 0 | 0 | 0 | 0 | 0 | 0 | | 0 | 0 | 0 | 0 | 0 | 0 | 0 | 0 |
| | 0 | 0 | 0 | 0 | 0 | 0 | 0 | 0 | | 0 | 0 | 0 | 0 | 0 | 0 | 0 | 0 |
| | 0 | 0 | 0 | 0 | 0 | 0 | 0 | 0 | | 0 | 0 | 0 | 0 | 0 | 0 | 0 | 0 |
| | 0 | 0 | 0 | 0 | 0 | 0 | 0 | 0 | | 37 | 210 | 228 | 120 | 215 | 55 | 157 | 207 |
| | 0 | 0 | 0 | 0 | 0 | 0 | 0 | 0 | | 13 | 310 | 14 | 153 | 157 | 328 | 164 | 218 |
| | 0 | 0 | 0 | 0 | 0 | 0 | 0 | 0 | | 0 | 0 | 0 | 0 | 0 | 0 | 0 | 0 |
| | 0 | 0 | 0 | 0 | 0 | 0 | 0 | 0 | | 169 | 264 | 140 | 150 | 113 | 221 | 130 | 77 |
| | 0 | 0 | 0 | 0 | 0 | 0 | 0 | 0 | | | | | | | | | |
| 1 | 6 | 1 | 0 | 0 | 8 | 1 | 0 | 10 | 4 | 6 | 0 | 0 | 0 | 7 | 14 | 8 | 14 |
| | 3 | 5 | 9 | 13 | 7 | 8 | 16 | 7 | | 2 | 5 | 314 | 132 | 200 | 157 | 21 | 1 |
| | 61 | 352 | 233 | 134 | 112 | 233 | 108 | 128 | | 203 | 326 | 137 | 213 | 41 | 271 | 201 | 9 |
| | 144 | 272 | 36 | 205 | 155 | 336 | 33 | 34 | | 125 | 382 | 298 | 183 | 218 | 98 | 3 | 145 |
| | 0 | 0 | 0 | 0 | 0 | 0 | 0 | 0 | | 204 | 273 | 252 | 121 | 190 | 284 | 198 | 160 |
| | 193 | 243 | 188 | 211 | 99 | 18 | 112 | 150 | | 63 | 232 | 311 | 96 | 211 | 121 | 131 | 216 |
| | 20 | 306 | 291 | 194 | 228 | 169 | 139 | 141 | | 181 | 277 | 235 | 155 | 219 | 144 | 134 | 65 |
| | 18 | 286 | 285 | 192 | 51 | 241 | 110 | 69 | | 177 | 292 | 261 | 220 | 140 | 140 | 163 | 228 |
| | 39 | 227 | 287 | 215 | 14 | 246 | 154 | 167 | | 146 | 265 | 116 | 189 | 189 | 137 | 148 | 5 |
| | 200 | 336 | 264 | 199 | 154 | 328 | 173 | 207 | | 218 | 255 | 223 | 131 | 249 | 346 | 193 | 128 |
| | 238 | 247 | 212 | 62 | 218 | 295 | 205 | 151 | | 152 | 354 | 43 | 45 | 23 | 294 | 56 | 145 |
| | 229 | 302 | 297 | 156 | 240 | 129 | 99 | 3 | | 121 | 282 | 129 | 221 | 210 | 327 | 116 | 90 |
| | 140 | 381 | 218 | 81 | 214 | 278 | 152 | 178 | | 169 | 365 | 181 | 116 | 224 | 134 | 21 | 163 |
| | 139 | 220 | 241 | 175 | 72 | 24 | 118 | 35 | | 212 | 299 | 278 | 209 | 181 | 98 | 84 | 223 |
| | 191 | 281 | 310 | 158 | 125 | 281 | 141 | 116 | | 48 | 221 | 317 | 102 | 222 | 111 | 32 | 89 |
| | 26 | 205 | 179 | 117 | 129 | 22 | 29 | 179 | | 23 | 304 | 314 | 198 | 185 | 119 | 153 | 61 |
| | 169 | 303 | 135 | 197 | 221 | 319 | 161 | 75 | | 241 | 319 | 190 | 64 | 160 | 70 | 170 | 176 |
| | 115 | 366 | 263 | 124 | 229 | 346 | 18 | 173 | | 59 | 351 | 29 | 122 | 22 | 257 | 50 | 99 |
| | 0 | 0 | 0 | 0 | 0 | 0 | 0 | 0 | | 184 | 343 | 316 | 162 | 161 | 326 | 143 | 77 |
| | 0 | 0 | 0 | 0 | 0 | 0 | 0 | 0 | | 221 | 344 | 132 | 64 | 138 | 341 | 164 | 45 |
| | 0 | 0 | 0 | 0 | 0 | 0 | 0 | 0 | | 3 | 356 | 266 | 222 | 34 | 341 | 128 | 133 |
| | 0 | 0 | 0 | 0 | 0 | 0 | 0 | 0 | | 0 | 0 | 0 | 0 | 0 | 0 | 0 | 0 |
| | 0 | 263 | 246 | 14 | 109 | 159 | 12 | 204 | | | | | | | | | |

(continued)

| $H_{BG}$ | $V_{i,j}$ | | | | | | | | $H_{BG}$ | $V_{i,j}$ | | | | | | | |
|---|---|---|---|---|---|---|---|---|---|---|---|---|---|---|---|---|---|
| Row index *i* | Lifting value set index $i_{LS}$ | | | | | | | | Row index *i* | Lifting value set index $i_{LS}$ | | | | | | | |
| | 0 | 1 | 2 | 3 | 4 | 5 | 6 | 7 | | 0 | 1 | 2 | 3 | 4 | 5 | 6 | 7 |
| | 1 | 3 | 0 | 0 | 2 | 12 | 16 | 13 | | 4 | 0 | 0 | 0 | 8 | 17 | 9 | 6 |
| | 154 | 331 | 115 | 39 | 243 | 40 | 62 | 79 | | 86 | 266 | 312 | 206 | 230 | 4 | 30 | 44 |
| | 156 | 242 | 309 | 59 | 19 | 271 | 57 | 182 | | 149 | 359 | 288 | 128 | 45 | 306 | 41 | 13 |
| | 18 | 247 | 278 | 167 | 226 | 293 | 149 | 68 | | 36 | 302 | 242 | 136 | 24 | 199 | 183 | 88 |
| | 118 | 365 | 297 | 206 | 220 | 241 | 171 | 119 | | 190 | 236 | 153 | 159 | 172 | 18 | 206 | 31 |
| | 183 | 342 | 308 | 187 | 41 | 146 | 177 | 176 | | 64 | 235 | 286 | 116 | 282 | 189 | 90 | 105 |
| | 115 | 323 | 261 | 114 | 114 | 222 | 48 | 190 | | 235 | 366 | 217 | 157 | 168 | 133 | 84 | 9 |
| 2 | 125 | 220 | 292 | 219 | 161 | 321 | 34 | 117 | 5 | 162 | 265 | 298 | 51 | 19 | 71 | 190 | 123 |
| | 0 | 0 | 0 | 0 | 0 | 0 | 0 | 0 | | 61 | 213 | 67 | 8 | 191 | 133 | 43 | 97 |
| | 53 | 201 | 76 | 174 | 242 | 291 | 4 | 46 | | 211 | 334 | 291 | 222 | 56 | 11 | 173 | 172 |
| | 0 | 0 | 0 | 0 | 0 | 0 | 0 | 0 | | 7 | 233 | 280 | 211 | 143 | 13 | 207 | 210 |
| | 128 | 344 | 259 | 139 | 54 | 91 | 155 | 127 | | 193 | 267 | 282 | 190 | 165 | 327 | 184 | 11 |
| | 0 | 0 | 0 | 0 | 0 | 0 | 0 | 0 | | 126 | 235 | 75 | 171 | 250 | 285 | 189 | 164 |
| | 73 | 377 | 293 | 211 | 183 | 63 | 110 | 203 | | 248 | 333 | 250 | 77 | 52 | 236 | 104 | 25 |
| | 223 | 298 | 227 | 208 | 267 | 116 | 98 | 126 | | 246 | 234 | 316 | 189 | 19 | 13 | 84 | 82 |
| | 50 | 319 | 114 | 189 | 122 | 185 | 127 | 93 | | 209 | 370 | 264 | 186 | 138 | 157 | 89 | 146 |
| | 158 | 350 | 190 | 190 | 155 | 224 | 147 | 39 | | 162 | 303 | 115 | 162 | 62 | 62 | 99 | 15 |
| | 192 | 259 | 220 | 180 | 68 | 35 | 193 | 89 | | 103 | 368 | 72 | 127 | 69 | 198 | 43 | 136 |
| | 238 | 197 | 186 | 131 | 179 | 302 | 13 | 197 | | 17 | 375 | 201 | 166 | 125 | 134 | 171 | 197 |
| | 0 | 0 | 0 | 0 | 0 | 0 | 0 | 0 | | 159 | 209 | 254 | 146 | 211 | 226 | 120 | 95 |
| | 196 | 276 | 298 | 88 | 106 | 89 | 7 | 95 | | 229 | 293 | 130 | 205 | 9 | 168 | 140 | 125 |
| | 0 | 0 | 0 | 0 | 0 | 0 | 0 | 0 | | 45 | 268 | 146 | 192 | 42 | 147 | 44 | 180 |

(d) The third table is shown in Table 3.

Table 3

| $\mathbf{H}_{BG}$ | $V_{i,j}$ | | | | | | | | $\mathbf{H}_{BG}$ | $V_{i,j}$ | | | | | | | |
|---|---|---|---|---|---|---|---|---|---|---|---|---|---|---|---|---|---|
| Row index $i$ | Lifting value set index $i_{LS}$ | | | | | | | | Row index $i$ | Lifting value set index $i_{LS}$ | | | | | | | |
| | 0 | 1 | 2 | 3 | 4 | 5 | 6 | 7 | | 0 | 1 | 2 | 3 | 4 | 5 | 6 | 7 |
| 6 | 7 | 4 | 0 | 0 | 14 | 18 | 20 | 6 | 41 | | | | | | | | |
| | 161 | 367 | 102 | 164 | 141 | 53 | 25 | 75 | | | | | | | | | |
| | 8 | 276 | 149 | 187 | 163 | 101 | 5 | 109 | | | | | | | | | |
| | 11 | 224 | 310 | 184 | 211 | 226 | 184 | 39 | | 15 | 7 | 5 | 7 | 11 | 8 | 0 | 23 |
| | 82 | 312 | 254 | 144 | 162 | 169 | 104 | 97 | | 60 | 365 | 108 | 209 | 49 | 14 | 52 | 175 |
| | 101 | 279 | 301 | 211 | 188 | 191 | 142 | 40 | | 215 | 276 | 86 | 199 | 190 | 46 | 67 | 126 |
| | 89 | 315 | 216 | 152 | 223 | 159 | 126 | 164 | | 138 | 366 | 202 | 66 | 126 | 3 | 121 | 220 |
| | 63 | 265 | 198 | 137 | 40 | 192 | 48 | 41 | | 62 | 377 | 231 | 115 | 42 | 22 | 88 | 77 |
| | 153 | 227 | 132 | 114 | 245 | 252 | 174 | 68 | | 0 | 0 | 0 | 0 | 0 | 0 | 0 | 0 |
| | 238 | 332 | 184 | 218 | 167 | 48 | 143 | 122 | | | | | | | | | |
| | 45 | 360 | 221 | 113 | 202 | 242 | 62 | 186 | | | | | | | | | |
| | 28 | 232 | 88 | 117 | 167 | 56 | 12 | 125 | | | | | | | | | |
| | 0 | 0 | 0 | 0 | 0 | 0 | 0 | 0 | | | | | | | | | |
| 7 | 1 | 0 | 0 | 0 | 0 | 12 | 17 | 4 | 43 | 2 | 3 | 3 | 1 | 6 | 12 | 20 | 12 |
| | 101 | 236 | 316 | 198 | 137 | 131 | 71 | 81 | | 30 | 239 | 199 | 173 | 258 | 157 | 63 | 144 |
| | 223 | 350 | 67 | 197 | 232 | 94 | 193 | 158 | | 28 | 325 | 235 | 187 | 200 | 18 | 55 | 37 |
| | 153 | 260 | 292 | 150 | 76 | 244 | 105 | 71 | | 69 | 365 | 251 | 146 | 268 | 275 | 114 | 127 |
| | 56 | 375 | 133 | 78 | 205 | 282 | 185 | 107 | | 103 | 271 | 170 | 54 | 278 | 127 | 40 | 32 |
| | 135 | 370 | 62 | 124 | 168 | 278 | 143 | 85 | | 0 | 0 | 0 | 0 | 0 | 0 | 0 | 0 |
| | 1 | 331 | 186 | 172 | 180 | 231 | 88 | 22 | | | | | | | | | |
| | 226 | 347 | 185 | 220 | 238 | 35 | 174 | 225 | | | | | | | | | |
| | 74 | 376 | 248 | 157 | 120 | 217 | 207 | 215 | | | | | | | | | |
| | 226 | 278 | 26 | 74 | 138 | 266 | 97 | 237 | | | | | | | | | |
| | 238 | 294 | 304 | 198 | 145 | 132 | 53 | 120 | | | | | | | | | |
| | 0 | 0 | 0 | 0 | 0 | 0 | 0 | 0 | | | | | | | | | |
| | 5 | 4 | 0 | 0 | 13 | 0 | 16 | 0 | | | | | | | | | |
| | 173 | 288 | 269 | 194 | 194 | 18 | 20 | 58 | | | | | | | | | |
| | 6 | 205 | 215 | 179 | 133 | 214 | 43 | 30 | | | | | | | | | |
| | 137 | 326 | 45 | 31 | 190 | 289 | 91 | 219 | | | | | | | | | |
| | 20 | 327 | 4 | 184 | 168 | 247 | 168 | 138 | | 0 | 9 | 8 | 6 | 8 | 12 | 19 | 8 |

(continued)

| $\mathbf{H}_{BG}$ | $V_{i,j}$ | | | | | | | | $\mathbf{H}_{BG}$ | $V_{i,j}$ | | | | | | | |
|---|---|---|---|---|---|---|---|---|---|---|---|---|---|---|---|---|---|
| Row index $i$ | Lifting value set index $i_{LS}$ | | | | | | | | Row index $i$ | Lifting value set index $i_{LS}$ | | | | | | | |
| | 0 | 1 | 2 | 3 | 4 | 5 | 6 | 7 | | 0 | 1 | 2 | 3 | 4 | 5 | 6 | 7 |
| 8 | 219<br>134<br>169<br>156<br>0<br>135<br>104<br>0 | 215<br>311<br>216<br>360<br>343<br>325<br>372<br>0 | 224<br>136<br>201<br>59<br>275<br>248<br>281<br>0 | 145<br>101<br>205<br>130<br>76<br>135<br>163<br>0 | 161<br>59<br>101<br>147<br>284<br>282<br>30<br>0 | 9<br>20<br>282<br>56<br>35<br>322<br>323<br>0 | 181<br>80<br>170<br>160<br>140<br>166<br>175<br>0 | 194<br>140<br>224<br>4<br>128<br>41<br>60<br>0 | 45 | 30<br>26<br>8<br>0 | 195<br>330<br>223<br>0 | 128<br>258<br>65<br>0 | 161<br>120<br>188<br>0 | 129<br>163<br>29<br>0 | 256<br>280<br>306<br>0 | 192<br>20<br>162<br>0 | 96<br>38<br>56<br>0 |
| 30 | 13<br>128<br>212<br>207<br>0 | 10<br>315<br>263<br>256<br>0 | 4<br>126<br>215<br>92<br>0 | 10<br>72<br>210<br>196<br>0 | 13<br>265<br>89<br>165<br>0 | 16<br>69<br>16<br>173<br>0 | 23<br>102<br>78<br>44<br>0 | 8<br>54<br>104<br>113<br>0 | 50 | 1 46<br>218<br>116<br>43<br>0 | 0 229<br>271<br>297<br>242<br>0 | 2 224<br>188<br>23<br>189<br>0 | 2 168<br>130<br>204<br>83<br>0 | 14 266<br>123<br>161<br>259<br>0 | 14 51<br>231<br>27<br>221<br>0 | 13 120<br>144<br>68<br>19<br>0 | 23 36<br>191<br>101<br>175<br>0 |
| 32 | 4<br>16<br>238<br>56<br>24<br>0 | 8<br>217<br>206<br>221<br>305<br>0 | 6<br>0<br>227<br>210<br>291<br>0 | 10<br>172<br>192<br>186<br>40<br>0 | 6<br>50<br>126<br>101<br>13<br>0 | 18<br>176<br>221<br>74<br>62<br>0 | 10<br>159<br>195<br>114<br>113<br>0 | 7<br>124<br>98<br>57<br>146<br>0 | 55 | 12<br>187<br>239<br>90<br>0 | 4<br>363<br>304<br>319<br>0 | 0<br>160<br>268<br>312<br>0 | 11<br>103<br>198<br>11<br>0 | 0<br>186<br>168<br>264<br>0 | 2<br>43<br>257<br>255<br>0 | 3<br>172<br>3<br>33<br>0 | 6<br>237<br>74<br>135<br>0 |
| 34 | 15<br>94<br>69<br>114<br>0 | 8<br>344<br>341<br>319<br>0 | 1<br>254<br>223<br>153<br>0 | 2<br>92<br>56<br>101<br>0 | 5<br>21<br>104<br>161<br>0 | 0<br>205<br>53<br>6<br>0 | 6<br>60<br>108<br>50<br>0 | 0<br>18<br>119<br>148<br>0 | 58 | 2 245<br>63<br>73<br>78<br>0 | 5 370<br>383<br>238<br>366<br>0 | 2 219<br>56<br>264<br>316<br>0 | 10 56<br>136<br>6<br>26<br>0 | 5 206<br>285<br>93<br>146<br>0 | 10 335<br>96<br>337<br>31<br>0 | 19 23<br>7<br>47<br>0<br>0 | 16 163<br>2<br>7<br>216<br>0 |
| 36 | 8<br>176<br>138<br>233<br>91<br>0 | 9<br>315<br>317<br>270<br>378<br>0 | 1<br>91<br>295<br>318<br>14<br>0 | 10<br>121<br>121<br>33<br>216<br>0 | 17<br>130<br>26<br>220<br>90<br>0 | 7<br>337<br>55<br>56<br>266<br>0 | 12<br>72<br>102<br>167<br>11<br>0 | 1<br>185<br>167<br>202<br>128<br>0 | | | | | | | | | |

(continued)

| $\mathbf{H}_{BG}$ | $V_{i,j}$ | | | | | | | | $\mathbf{H}_{BG}$ | $V_{i,j}$ | | | | | | | |
|---|---|---|---|---|---|---|---|---|---|---|---|---|---|---|---|---|---|
| Row index $i$ | Lifting value set index $i_{LS}$ | | | | | | | | Row index $i$ | Lifting value set index $i_{LS}$ | | | | | | | |
| | 0 | 1 | 2 | 3 | 4 | 5 | 6 | 7 | | 0 | 1 | 2 | 3 | 4 | 5 | 6 | 7 |
| 40 | 3<br>85<br>58<br>190<br>204<br>0 | 10<br>268<br>0<br>203<br>273<br>0 | 9<br>90<br>57<br>134<br>251<br>0 | 4<br>40<br>16<br>161<br>56<br>0 | 8<br>169<br>97<br>173<br>197<br>0 | 21<br>265<br>321<br>209<br>78<br>0 | 3<br>84<br>84<br>173<br>30<br>0 | 28<br>0<br>24<br>233<br>146<br>0 | | | | | | | | | |

In another possible implementation, the storage matrix may alternatively be stored in a manner of storing all connection relationships and all shifting values in the storage matrix. In this case, the storage matrix may be obtained based on a first table and a fourth table. The first table includes all connection relationships of the storage matrix. The fourth table includes shifting values of all non-zero elements of the storage matrix. Alternatively, the storage matrix may be a fifth table. The fifth table includes both all connection relationships of the storage matrix and shifting values of all non-zero elements of the storage matrix.

In the foregoing implementation, content stored in the transmit end includes the indication sequence, the first table, and the fourth table, or the indication sequence and the fifth table.

It should be noted that when split extension is not performed, the transmit end stores the first table and the fourth table or stores the fifth table, but does not store the indication sequence. In this case, the LDPC base matrix may be obtained by directly reading the storage matrix based on a target code rate.

The following describes a feature of the storage matrix in embodiments of this application.

In a possible implementation, the storage matrix is an $M \times N$ matrix. The storage matrix may be divided into five parts shown in FIG. 4. Specifically, the storage matrix includes a submatrix A1, a submatrix B1, a submatrix C1, a submatrix D1, and a submatrix E1. The submatrix A1 is $1^{st}$ to $m_1^{th}$ rows and $1^{st}$ to $n_1^{th}$ columns of the storage matrix. The submatrix B1 is the $1^{st}$ to $m_1^{th}$ rows and $(n_1 + 1)^{th}$ to $n_2^{th}$ columns of the storage matrix. The submatrix C1 is the $1^{st}$ to $m_1^{th}$ rows and $(n_2 + 1)^{th}$ to $N^{th}$ columns of the storage matrix. The submatrix D1 is $(m_1 + 1)^{th}$ to $M^{th}$ rows and the $1^{st}$ to $n_2^{th}$ columns of the storage matrix. The submatrix E1 is the $(m_1 + 1)^{th}$ to $M^{th}$ rows and the $(n_2 + 1)^{th}$ to $N^{th}$ columns of the storage matrix. The submatrix A1 and the submatrix B1 form the core matrix of the storage matrix. The submatrix C1 and the submatrix E1 correspond to extended nodes of the storage matrix. The submatrix D1 and the submatrix E1 correspond to extended rows of the storage matrix.

The submatrix E1 is an identity matrix or a lower triangular matrix.

The first row in the row pair indicated by the indication information belongs to the submatrix D1 and the submatrix E1. Correspondingly, the second row belongs to the submatrix D1 and the submatrix E1 or belongs to the submatrix A1, the submatrix B1, and the submatrix C1.

That the shifting value of the non-zero element in the first row corresponds to the shifting value of the non-zero element in the second row may be specifically that shifting values of non-zero elements in first $n_2$ elements of the first row correspond to shifting values of non-zero elements in first $n_2$ elements of the second row.

That the shifting values of the non-zero elements other than the extended node in the first row are properly included in the shifting values of the non-zero elements other than the extended node in the second row may be specifically that the shifting values of the non-zero elements in the first $n_2$ elements in the first row are properly included in the shifting values of the non-zero elements in the first $n_2$ elements of the second row.

That the sums of the fixed value and the shifting values of the non-zero elements other than the extended node in the first row are properly included in the shifting values of the non-zero elements other than the extended node in the second row may be specifically that sums of the fixed value and the shifting values of the non-zero elements in the first $n_2$ elements of the first row are properly included in the shifting values of the non-zero elements in the first $n_2$ elements of the second row. Optionally, when an $i^{th}$ position of the indication sequence is the first character, a quantity of pairwise orthogonal third rows in first i rows of the storage matrix is less than or equal to a sum of 1 and a maximum quantity of splitting times of (i - 1) rows corresponding to first (i - 1) positions of the indication sequence. i is an integer greater than 1. A quantity of splitting times of a row is a total quantity of splitting times of the row and a row generated by splitting the row. The row generated by splitting the row includes a row directly or indirectly generated by splitting the row. For example, if a row #3 is split to generate rows #5 and #9, the row #5 is split to generate a row #7, and the row #7 is split to generate a row #19, the rows #5 and #9 are rows directly obtained by splitting the row #3, the rows #7 and #19 are rows indirectly obtained by splitting the row #3, a quantity of splitting times of the row #3 is 4, a quantity of splitting times of the row #5 is 2, a quantity of splitting times of the row #7 is 1, and quantities of splitting times of the rows #9 and #19 are 0.

The following provides a general description of the feature of the storage matrix.

The storage matrix is denoted as $H_0$, and the indication sequence is denoted as $\theta$.

Rows of the storage matrix $H_0$ are in a one-to-one correspondence with elements in the indication sequence $\theta$. A quantity of rows of the storage matrix $H_0$ is equal to a length of the indication sequence $\theta$. If $\theta(i) \neq \alpha$, $N(i) \subseteq N(\theta(i))$. $N$ represents a variable node adjacent to a check equation. In the storage matrix $H_0$, variable nodes (other than an extended node) contained in a row other than a row in the core matrix and a row corresponding to the first character are properly included in variable nodes contained in its parent node, on which splitting is performed. In the storage matrix $H_0$, a shifting value of the row other than the row in the core matrix and the row corresponding to the first character differs from a shifting value at a corresponding position of its parent node by a fixed constant k. When k is 0, it indicates that the shifting value of the row is the same as the shifting value at the corresponding position of its parent node. An extended node of the storage matrix $H_0$ has a value of 1 at its diagonal position and is a lower triangular structure. The storage matrix is a check matrix, but not a decoding matrix.

Given a row $i$, for the LDPC base matrix $H_i$, a current quantity of splitting rounds is defined as a maximum quantity

$S(H_i)$ of splitting times of all rows of $H_i$. It is clear that a core part (namely, a part other than an extended node) of a check equation and all its subnodes obtained through splitting is completely orthogonal, that is, a quantity of equivalent decoded rows is 1. A decoding parallelism degree is $S(H_i) + 1$ when the quantity of equivalent decoded rows is 1. If $\theta(i) = \alpha$, a quantity of rows orthogonal to a row $i$ is less than or equal to $S(H_i) + 1$, and all such rows correspond to the first characters in the indication sequence, that is, a parallelism degree of decoded rows is not greater than a parallelism degree of rows generated through a current split. In this way, when conventional extension is performed for low-code-rate extension, the quantity of equivalent decoded rows slowly increases with a low slope as a code rate of the LDPC base matrix decreases, leading to as little additional hardware complexity as possible.

There may be no correlation between a row corresponding to a first character and a row generated through splitting in the storage matrix. However, there may be a correlation between rows corresponding to first characters. For example, their connection relationships are orthogonal. Optionally, a plurality of first characters may be set in the indication sequence, or in other words, the first characters have various values, to indicate a correlation of a check equation generated through conventional extension. For example, connection relationships of rows in the storage matrix that correspond to first characters with a same value are orthogonal to each other. In this case, for the storage matrix, a correlation between rows generated through splitting means proper inclusion of a connection relationship (and a correspondence between shifting values), and a correlation between rows generated through conventional extension means that their connection relationships are orthogonal to each other.

Column weight distribution of the storage matrix, as shown in FIG. 8:

1. Degrees of variable nodes other than an extended node are regular. Column weights of non-extended columns are evenly distributed.
2. If at least one split extension is performed in a process of generating the LDPC base matrix, column weights of some or all non-extended columns of the storage matrix are greater than those of corresponding non-extended columns of the LDPC base matrix, and/or column weights of some or all extended columns of the storage matrix are less than those of corresponding extended columns of the LDPC base matrix.

In other words, a sum of column weights of a core part of the LDPC base matrix is less than a sum of column weights of a part that is of the storage matrix and that corresponds to the core part of the LDPC base matrix; and/or a sum of column weights of an extended part of the LDPC base matrix is greater than a sum of column weights of a part that is of the storage matrix and that corresponds to the extended part of the LDPC base matrix.

Row weight distribution of the storage matrix:

1. A row weight of the storage matrix is related not only to a quantity of splitting rounds, but also to segments and element values of the indication sequence. A row weight trend of each segment is different. Different from the storage matrix in embodiments of this application, a row weight of a storage matrix in Patent Application No. PCT/CN2022/132833 is strongly correlated with the quantity of splitting rounds. In the storage matrix in this patent application, row weights of rows corresponding to a same round of splitting are evenly distributed, and the row weight significantly decreases as the quantity of splitting rounds increases.
2. The row weight of the storage matrix does not tend to be a small positive integer as a code rate decreases, and a corresponding code rate has no lower bound. Different from the storage matrix in embodiments of this application, the row weight of the storage matrix in Patent Application No. PCT/CN2022/132833 decreases as the quantity of splitting rounds increases, and finally approaches 2, and a corresponding code rate has a clear lower bound.
3. The storage matrix in embodiments of this application enters a hybrid region of split extension and conventional extension. A proportion of conventional extension increases as the code rate decreases. Correspondingly, the indication sequence enters the hybrid region, and a proportion of first characters gradually increases as the code rate decreases.

FIG. 9 shows an example of content stored at a transmit end. As shown in FIG. 8, a first column of a matrix is an indication sequence, and the remaining part is a storage matrix. A row weight of the storage matrix decreases from top to bottom. A submatrix E1 of the storage matrix may be an identity matrix or a lower triangular matrix. There is an orthogonal relationship between rows of the storage matrix that correspond to first characters (positions with a value of 60 in the indication sequence in FIG. 8).

(2) Manner of obtaining the LDPC base matrix based on the storage matrix and the indication sequence

Given $K$ information bits c, a check matrix $H$ is determined. $N$ - $K$ parity bits w are obtained through $H \times \begin{bmatrix} c \\ w \end{bmatrix} = 0$. The check matrix $H$ is obtained by lifting and translating the LDPC base matrix. The LDPC base matrix is denoted as $H_{BG}$ below.

For example, the transmit end stores the indication sequence, the first table, the second table, and the third table. For descriptions of the indication sequence, the first table, the second table, and the third table, refer to the foregoing descriptions.

A connection relationship between a variable node and a check node of $\boldsymbol{H_{BG}}$ is obtained from the first table. In $H_{BG}$, all positions described in the first table are non-zero elements, and the other positions are zero elements. Each non-zero element of $\boldsymbol{H_{BG}}$ is extended to a $Z_c \times Z_c$ identity translation matrix. Its shifting value is obtained from the indication sequence, the second table, and the third table. A specific manner includes the following three cases: 1. A shifting value of the core matrix is directly read from the second table. 2. A shifting value of a non-zero element in a row obtained through conventional extension is directly read from the third table. 3. A shifting value of a non-zero element in a row r obtained through split extension is a sum of a fixed offset and a shifting value at a same position of a row in the indication sequence $\theta$ $(r)$. The fixed offset is a value related to r. $Z_c$ is a lifting value.

It is assumed that the storage matrix is $H_0$, a quantity of core check rows of the storage matrix $H_0$ is $M_1$, a quantity of columns is $N_1$, and the indication sequence is $\theta$. A matrix $H_i$ (a matrix of first $i$ rows and $N_1$ columns) is constructed in ascending order of row quantity $i$ from $M_1$. $H_{M_1}(t, k) = H_0(t, k)$, where $1 \le t \le M_1$ and $1 \le k \le N_1$.

For a row quantity $i + 1$:

If $\theta(i+1) \neq \alpha$, elimination is performed on a $\theta(i+1)^{th}$ row with an $(i+1)^{th}$ row to replace the $\theta(i+1)^{th}$ row, that is, $H_{i+1}(\theta(i+1), k) \geq [H_i(\theta(i+1), k) + H_0(i+1, k)] \pmod 2$. $H_{i+1}(i+1, k) = H_0(i+1, k)$ and $H_{i+1}(t, k) = H_i(t, k)$, where $t \neq \theta(i+1)$ $1 \leq t \leq i$, and $1 \le k \le N_1$.

If $\theta(i + 1) = \alpha$, $H_{i+1}(i + 1, k) = H_0(i + 1, k)$. $H_{i+1}(t, k) = H_i(t, k)$, where $1 \le t \le i$ and $1 \le k \le N_1$.

In addition, in embodiments of this application, a length R of the indication sequence $\theta$ may be determined based on a code length corresponding to the LDPC base matrix, a quantity of information bits corresponding to the LDPC base matrix, a quantity of punctured information columns, and a quantity of information columns in the LDPC base matrix. R is a minimum integer that meets a condition $RZ_c \geq N_0 - K_0 + K_1$. $Z_c$ is a lifting value. $Z_c$ is minimum $Z_c$ that meets a condition $KZ_c \geq K_0$ in a $Z_c$ list. $N_0$ is the code length corresponding to the LDPC base matrix. $K_0$ is the quantity of information bits corresponding to the LDPC base matrix. K is the quantity of information columns in the LDPC base matrix. $K_1$ is the quantity of punctured information columns.

The following describes selection of a low-code-rate extension manner (or selection of indication information) in embodiments of this application.

For example, a low-code-rate matrix $H_{m+1 \times n+1}$ is constructed from a matrix $H_{m \times n}$. For an extended node, only the last extended node is a non-zero element. For a variable node other than the extended nodes, there are two manners: split extension and conventional extension.

An evaluation criterion is to calculate optimal decoding thresholds of extended rows newly added through split extension and conventional extension.

(1) In split extension, degree distribution $dv_{H_{m+1 \times n+1}}(1{:}\ n) = dv_{H_{m \times n}}(1{:}n)$ of variable nodes remains unchanged, and degree distribution $dc_{H_{m+1 \times n+1}}([1{:}\ m] \setminus \{m, f(m)\})$ of check nodes is the same as that of $H_{m \times n}$. Optimizable space is $dc_{H_{m+1 \times n+1}}(m)$ and $dc_{H_{m+1 \times n+1}}(f(m))$. $f(m)$ is a parent node split to obtain m.

(2) In conventional extension, degree distribution $dv_{H_{m+1 \times n+1}}(1{:}\ n) \le 1 + dv_{H_{m \times n}}(1{:}\ n)$ of variable nodes is optimizable, and degree distribution of check nodes is $dc_{H_{m+1 \times n+1}}(1{:}\ m) = dc_{H_{m \times n}}(1{:}m)$.

A basic principle is to maintain an optimal edge density as far as possible during each extension. The core matrix needs an extremely high edge density to ensure performance. In a process of extending to a low code rate, to ensure performance at the low code rate, an overall edge density is reduced by newly adding a row through split extension and increased by newly adding a row through conventional extension.

The indication sequence is derived by optimizing a decoding threshold: Conventional extension is first performed because a high edge density is needed at a high code rate. As the code rate decreases, an edge density corresponding to a better decoding threshold decreases, and a split extension region is entered. When the edge density decreases to a specific value, the hybrid region is entered. The indication sequence obtained by optimizing the decoding threshold has an obvious segmentation feature. Although specific indication sequences are different, a sequence feature generated through an optimized threshold is relatively clear.

FIG. 10 shows two examples of indication sequences. In FIG. 10, a split index is an index of a split on a parent check node, a check index is an index of a check node, a vertical axis above 0 is split extension, and a vertical axis below 0 is conventional extension.

For a check node other than a core check (or referred to as a core matrix) of an indication sequence shown on the left side of FIG. 10: 1. First, conventional extension is continuously performed. 2. Next, split extension is continuously performed. 3. Then, split extension and conventional extension are alternately performed.

For a check node other than a core check (or referred to as a core matrix) of an indication sequence shown on the right side of FIG. 10: 1. First, split extension and conventional extension are alternately performed. 2. Next, split extension is continuously performed. 3. Then, split extension and conventional extension are alternately performed.

FIG. 11 is a schematic flowchart of an LDPC code-based communication method 1100 according to this application.

The method 1100 may be performed by a receive end, or a module or unit in the receive end, hereinafter collectively referred to as the receive end for ease of description. The method 1100 may include at least a part of the following content.

Step 1101: The receive end receives an LDPC coding bit sequence from a transmit end.

Step 1102: The receive end decodes the LDPC coding bit sequence based on an LDPC base matrix. The LDPC base matrix may be obtained based on a storage matrix and indication information. The LDPC base matrix may be a matrix actually used by the receive end. The storage matrix may be a matrix stored in the receive end or a matrix predefined in a protocol. The LDPC base matrix may also be referred to as a decoding matrix.

The storage matrix, the indication information, the LDPC base matrix, and a manner of obtaining the LDPC base matrix based on the storage matrix and the indication information at the receive end are similar to those at the transmit end. For details, refer to the description of the transmit end. Details are not described again.

It should be noted that the LDPC base matrix used by the receive end may be the same as or different from that used by the transmit end. For example, the transmit end may only read the storage matrix based on the indication information without performing split extension, and the receive end may read the storage matrix based on the indication information and perform split extension. In this case, the LDPC base matrix used by the transmit end may be different from that used by the receive end. For another example, the transmit end may read the storage matrix based on the indication information and perform split extension, and the receive end may read the storage matrix based on the indication information and perform split extension. In this case, the LDPC base matrix used by the transmit end may be different from that used by the receive end.

The following describes performance of an LDPC code in embodiments of this application with reference to FIG. 12 to FIG. 16.

FIG. 12 shows a simulation result of a quantity of equivalent decoded rows of an LDPC code according to an embodiment of this application. Hybrid extension corresponds to the LDPC code in embodiments of this application.

As shown in FIG. 12, in a high-code-rate core matrix and during initial conventional extension, the quantity of equivalent decoded rows of the LDPC code in embodiments of this application is close to that of an NR LDPC code. In a split extension phase for low-code-rate extension, the quantity of equivalent decoded rows of the LDPC code in embodiments of this application does not increase as a code rate decreases. In a phase of alternately performing split extension and conventional extension (or in other words, performing hybrid extension), the quantity of equivalent decoded rows of the LDPC code in embodiments of this application slowly increases as the code rate decreases. It can be learned that in the last two phases, the quantity of equivalent decoded rows of the LDPC code in embodiments of this application is significantly less than that of the NR LDPC code.

FIG. 13 shows a simulation result of an average quantity of decoding iterations of an LDPC code according to an embodiment of this application. Hybrid extension corresponds to the LDPC code in embodiments of this application. FIG. 13 shows a result of an average quantity of decoding iterations at a 1-bit granularity (1-bit granularity).

As shown in FIG. 13, in a high-code-rate phase, an average convergence speed of an NR LDPC code is approximately 6.x iterations, and that of the LDPC code in embodiments of this application is approximately 3.x iterations, with power consumption and average latency differences of nearly 1 time. In a low-code-rate phase, performance of the LDPC code in embodiments of this application is better than that of the NR LDPC code, and a structure without puncturing and a large column weight still features fast convergence at a lower signal-to-noise ratio (Signal Noise Ratio, SNR).

FIG. 14 shows a simulation result of an aligned quantity of equivalent decoded rows of an LDPC code according to an embodiment of this application. Hybrid extension corresponds to the LDPC code in embodiments of this application.

Structural support: 1. Degree distribution is even. 2. There is no puncturing position. 3. Two rows obtained through split extension are orthogonal, and a decoding threshold is good for a small quantity of iterations. 4. Hybrid low-code-rate extension is performed for a better edge density.

As shown in FIG. 14, for an aligned quantity of iterations of the LDPC code in embodiments of this application: 1. For an extreme quantity of iterations, its performance is close to that of an NR LDPC code, with a difference of less than 0.1 dB. 2. For a small quantity of iterations, it has a large performance advantage over the NR LDPC code. Their performance is close at a low code rate. An advantage of the LDPC code in embodiments of this application is extended as a code rate decreases.

FIG. 15 shows a simulation result of an error floor (error floor) of an LDPC code according to an embodiment of this application. Hybrid extension corresponds to the LDPC code in embodiments of this application.

As shown in FIG. 15, an upper triangular extended structure of the LDPC code in embodiments of this application may cause a slight performance loss between waterfall (waterfall) regions, but has a great benefit for the error floor due to a reduction of (*a + b, 0)* - TS.

Structural support for hybrid extension: An encoding matrix has an extended node with a diagonal structure, which can support IR-HARQ and parallel encoding. A check matrix has an extended node with an upper triangular structure, which avoids a small trapping set (Trapping Set) and reduces the error floor.

In comparison with a check matrix of an LDPC code that supports IR-HARQ, an edge between extended nodes appears at an upper triangular position. In comparison with a check matrix generated through only split extension, an extended part of hybrid extension includes a one-degree extended node.

FIG. 16 shows a simulation result of performance of an LDPC code in low-bit quantization according to an embodiment of this application. Hybrid extension corresponds to the LDPC code in embodiments of this application.

As shown in FIG. 16, for the LDPC code in embodiments of this application, a core part has regular variable node degree distribution, density evolution is more balanced, and an amplitude difference between nodes $v_{all}$ is smaller. In lower-bit quantization, the performance is better than that of an NR LDPC code, and a performance loss is smaller than that of a floating-point code.

It should be noted that the foregoing embodiments of this application may be independently implemented, or may be implemented together in a proper manner. This is not limited in this application.

The methods provided in this application are described in detail above with reference to FIG. 6 to FIG. 16. Apparatus embodiments of this application are described in detail below with reference to FIG. 17 and FIG. 18.

It may be understood that to implement the functions in the foregoing embodiments, an apparatus in FIG. 17 or FIG. 18 includes a corresponding hardware structure and/or software module for performing each function. A person skilled in the art should be easily aware that in this application, the units and method steps in the examples described with reference to embodiments disclosed in this application can be implemented by hardware or a combination of hardware and computer software.

FIG. 17 and FIG. 18 each are a diagram of a structure of a possible apparatus according to an embodiment of this application. These apparatuses may be configured to implement functions of the transmit end or the receive end in the foregoing method embodiments. Therefore, beneficial effects of the foregoing method embodiments can also be implemented.

As shown in FIG. 17, an apparatus 10 includes a transceiver unit 11 and a processing unit 12.

When the apparatus 10 is configured to implement a function of the transmit end in the foregoing method embodiments, the transceiver unit 11 is configured to obtain an information bit sequence. The processing unit 12 is configured to perform LDPC encoding on the information bit sequence based on an LDPC base matrix to obtain an LDPC coding bit sequence. The LDPC base matrix is obtained based on a storage matrix and indication information. The indication information includes first information and second information. The first information indicates one or more row pairs. Each of the one or more row pairs corresponds to two rows of the storage matrix. A shifting value of a non-zero element in a first row of the two rows corresponds to a shifting value of a non-zero element in a second row of the two rows. The second information indicates one or more third rows. The one or more third rows of the LDPC base matrix are the same as the one or more third rows of the storage matrix. The transceiver unit 11 is further configured to send the LDPC coding bit sequence.

When the apparatus 10 is configured to implement a function of the receive end in the foregoing method embodiments, the transceiver unit 11 is configured to receive an LDPC coding bit sequence from the transmit end. The processing unit 12 is configured to decode the LDPC coding bit sequence based on an LDPC base matrix. The LDPC base matrix is obtained based on a storage matrix and indication information. The indication information includes first information and second information. The first information indicates one or more row pairs. Each of the one or more row pairs corresponds to two rows of the storage matrix. A shifting value of a non-zero element in a first row of the two rows corresponds to a shifting value of a non-zero element in a second row of the two rows. The second information indicates one or more third rows. The one or more third rows of the LDPC base matrix are the same as the one or more third rows of the storage matrix.

Optionally, a row that is of the LDPC base matrix and that corresponds to the first row is the same as the first row; and a row that is of the LDPC base matrix and that corresponds to the second row is obtained by performing elimination on the second row with the first row.

Optionally, the storage matrix is obtained based on a first table, a second table, and a third table. The first table includes a connection relationship between a variable node and a check node of the storage matrix. The second table includes a shifting value of a non-zero element in a core matrix of the storage matrix. The third table includes a shifting value of a non-zero element in the one or more third rows.

Optionally, a form used for the indication information includes at least one of an indication sequence, a mapping table, or a mapping pair.

Optionally, the indication information is in a form of an indication sequence. A length of the indication sequence is equal to a quantity of rows of the LDPC base matrix. The first information includes a row number of a second row in each of the one or more row pairs. A row number of a first row in the row pair is a position of the row number of the second row in the row pair in the indication sequence. The position of the row number of the second row in the row pair in the indication sequence is greater than the row number of the first row in the row pair. The second information includes one or more first characters. Positions of the one or more first characters in the indication sequence correspond to row numbers of the one or more third rows.

Optionally, the first character is a value other than a row number of the storage matrix.

Optionally, the second information includes a plurality of first characters, and values of the plurality of first characters are the same.

Optionally, some or all of a plurality of third rows corresponding to the plurality of first characters are pairwise orthogonal.

Optionally, the second information includes a plurality of first characters, the plurality of first characters include at least two types of values, and third rows corresponding to first characters with a same value are pairwise orthogonal.

Optionally, the indication sequence sequentially includes a first segment, a second segment, a third segment, and a fourth segment. The first segment corresponds to the core matrix of the storage matrix. The first segment consists of one or more first row numbers or one or more second characters. The second segment consists of one or more third characters. The third segment consists of one or more second row numbers. The fourth segment is formed by interleaving one or more fourth characters and one or more third row numbers. The row number in the first information sequentially includes the one or more first row numbers, the one or more second row numbers, and the one or more third row numbers. The one or more first characters sequentially include the one or more second characters, the one or more third characters, and the one or more fourth characters.

Optionally, when the first segment consists of the one or more first row numbers, the one or more second row numbers include at least one or all of the one or more first row numbers.

Optionally, the one or more third row numbers include at least one or all of row numbers of third rows corresponding to the one or more fourth characters.

Optionally, a proportion of the fourth characters in the fourth segment increases as a code rate corresponding to the LDPC base matrix decreases.

Optionally, an $i^{th}$ position of the indication sequence is the first character. A quantity of pairwise orthogonal third rows in first i rows of the storage matrix is less than or equal to a sum of 1 and a maximum quantity of splitting times of (i - 1) rows corresponding to first (i - 1) positions of the indication sequence. i is an integer greater than 1.

Optionally, the storage matrix is an $M \times N$ matrix. The storage matrix includes a submatrix A1, a submatrix B1, a submatrix C1, a submatrix D1, and a submatrix E1. The submatrix A1 is $1^{st}$ to $m_1^{th}$ rows and $1^{st}$ to $n_1^{th}$ columns of the storage matrix. The submatrix B1 is the $1^{st}$ to $m_1^{th}$ rows and $(n_1 + 1)^{th}$ to $n_2^{th}$ columns of the storage matrix. The submatrix C1 is the $1^{st}$ to $m_1^{th}$ rows and $(n_2 + 1)^{th}$ to $N^{th}$ columns of the storage matrix. The submatrix D1 is $(m_1 + 1)^{th}$ to $M^{th}$ rows and the $1^{st}$ to $n_2^{th}$ columns of the storage matrix. The submatrix E1 is the $(m_1 + 1)^{th}$ to $M^{th}$ rows and the $(n_2 + 1)^{th}$ to $N^{th}$ columns of the storage matrix. That the shifting value of the non-zero element in the first row corresponds to the shifting value of the non-zero element in the second row includes: shifting values of non-zero elements in first $n_2$ elements of the first row correspond to shifting values of non-zero elements in first $n_2$ elements of the second row. The first $n_2$ elements of the second row are rows in a matrix formed by the submatrix A1 and the submatrix B1 or rows in the submatrix D1.

Optionally, that the shifting values of the non-zero elements in the first $n_2$ elements of the first row correspond to the shifting values of the non-zero elements in the first $n_2$ elements of the second row includes: the shifting values of the non-zero elements in the first $n_2$ elements of the first row are properly included in the shifting values of the non-zero elements in the first $n_2$ elements of the second row; or sums of a fixed value and the shifting values of the non-zero elements in the first $n_2$ elements of the first row are properly included in the shifting values of the non-zero elements in the first $n_2$ elements of the second row.

Optionally, the submatrix E1 is a lower triangular matrix.

Optionally, a sum of column weights of a core part of the LDPC base matrix is less than a sum of column weights of a part that is of the storage matrix and that corresponds to the core part of the LDPC base matrix; and/or a sum of column weights of an extended part of the LDPC base matrix is greater than a sum of column weights of a part that is of the storage matrix and that corresponds to the extended part of the LDPC base matrix.

Optionally, the processing unit 12 is further configured to: read the indication information whose length is R based on a code length corresponding to the LDPC base matrix, a quantity of information bits corresponding to the LDPC base matrix, a quantity of punctured information columns, and a quantity of information columns in the LDPC base matrix; and obtain the LDPC base matrix based on the storage matrix and the indication information. R is a minimum integer that meets a condition $RZ_c \geq N_0 - K_0 + K_1$. $Z_c$ is a lifting value. $Z_c$ is minimum $Z_c$ that meets a condition $KZ_c \geq K_0$ in a $Z_c$ list. $N_0$ is the code length corresponding to the LDPC base matrix. $K_0$ is the quantity of information bits corresponding to the LDPC base matrix. K is the quantity of information columns in the LDPC base matrix. $K_1$ is the quantity of punctured information columns.

For more detailed descriptions of the transceiver unit 11 and the processing unit 12, refer to related descriptions in the foregoing method embodiments. Details are not described herein again.

As shown in FIG. 20, an apparatus 20 includes a processor 21. The processor 21 is coupled to a memory 23. The memory 23 is configured to store instructions. When the apparatus 20 is configured to implement the foregoing method, the processor 21 is configured to execute the instructions in the memory 23, to implement a function of the foregoing processing unit 12.

Optionally, the apparatus 20 further includes the memory 23.

Optionally, the apparatus 20 further includes an interface circuit 22. The processor 21 and the interface circuit 22 are coupled to each other. It may be understood that the interface circuit 22 may be a transceiver or an input/output interface. When the apparatus 20 is configured to implement the foregoing method, the processor 21 is configured to execute the instructions to implement the function of the foregoing processing unit 12, and the interface circuit 22 is configured to implement a function of the foregoing transceiver unit 11.

For example, when the apparatus 20 is a chip used at a transmit end or a receive end, the chip implements a function of the transmit end or the receive end in the foregoing method embodiments. The chip receives information from another module (for example, a radio frequency module or an antenna) in the transmit end or the receive end, where the information is sent by another apparatus to the transmit end or the receive end; or the chip sends information to another module (for example, a radio frequency module or an antenna) in the transmit end or the receive end, where the information is sent by the transmit end or the receive end to another apparatus.

This application further provides a communication apparatus, including a processor. The processor is coupled to a memory. The memory is configured to store a computer program or instructions and/or data. The processor is configured to: execute the computer program or the instructions stored in the memory, or read the data stored in the memory, to perform the method in the foregoing method embodiments. Optionally, there are one or more processors. Optionally, the communication apparatus includes the memory. Optionally, there are one or more memories. Optionally, the memory and the processor are integrated together or disposed separately.

This application further provides a computer-readable storage medium. The computer-readable storage medium stores computer instructions used for implementing the method performed by the transmit end or the receive end in the foregoing method embodiments.

This application further provides a computer program product, including instructions. When the instructions are executed by a computer, the method performed by the transmit end or the receive end in the foregoing method embodiments is implemented.

This application further provides a communication system. The communication system includes at least one of the transmit end or the receive end in the foregoing embodiments.

For explanations and beneficial effects of related content in any one of the apparatuses provided above, refer to the corresponding method embodiments provided above. Details are not described herein again.

It may be understood that the processor in embodiments of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware component, or any combination thereof. The general-purpose processor may be a microprocessor, any regular processor, or the like.

The method steps in embodiments of this application may be implemented in a hardware manner, or may be implemented in a manner of executing software instructions by the processor. The software instructions may include a corresponding software module. The software module may be stored in a random access memory, a flash memory, a read-only memory, a programmable read-only memory, an erasable programmable read-only memory, an electrically erasable programmable read-only memory, a register, a hard disk, a removable hard disk, a compact disc read-only memory (compact disc read-only memory, CD-ROM), or any other form of storage medium well-known in the art. For example, a storage medium is coupled to a processor, so that the processor can read information from the storage medium and write information to the storage medium. Certainly, the storage medium may alternatively be a component of the processor. The processor and the storage medium may be disposed in an ASIC. In addition, the ASIC may be located at a transmit end or a receive end. Certainly, the processor and the storage medium may alternatively exist in a transmit end or a receive end as discrete components.

All or some of the foregoing embodiments may be implemented by using software, hardware, firmware, or any combination thereof. When software is used to implement the embodiments, all or some of the embodiments may be implemented in a form of a computer program product. The computer program product includes one or more computer programs or instructions. When the computer programs or instructions are loaded and executed on a computer, the procedures or functions in embodiments of this application are all or partially executed. The computer may be a general-purpose computer, a dedicated computer, a computer network, a network device, user equipment, or another programmable apparatus. The computer programs or instructions may be stored in a computer-readable storage medium, or may be transmitted from a computer-readable storage medium to another computer-readable storage medium. For example, the computer programs or instructions may be transmitted from a website, computer, server, or data center to another website, computer, server, or data center in a wired or wireless manner. The computer-readable storage medium may be any usable medium that can be accessed by the computer, or a data storage device, for example, a server or a data center, integrating one or more usable media. The usable medium may be a magnetic medium, for example, a floppy disk, a hard disk, or a magnetic tape; or may be an optical medium, for example, a digital video disc; or may be a semiconductor medium, for example, a solid-state drive.

In various embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment.

It may be understood that various numbers in embodiments of this application are merely used for differentiation for ease of description, and are not used to limit the scope of embodiments of this application. Sequence numbers of the foregoing processes do not mean an execution sequence, and the execution sequence of the processes should be determined based on functions and internal logic of the processes.

Unless otherwise stated, meanings of all technical and scientific terms used in embodiments of this application are the same as those usually understood by a person skilled in the technical field of this application. The terms used in this application are merely intended to describe objectives of specific embodiments, and are not intended to limit the scope of this application. It should be understood that the foregoing is an example for description, and the foregoing examples are merely intended to help a person skilled in the art understand embodiments of this application, but are not intended to limit embodiments of this application to examples of specific values or specific scenarios. It is clear that a person skilled in the art can make various equivalent modifications or variations based on the examples described above, and such modifications and variations also fall within the scope of embodiments of this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

**1.** A low-density parity-check LDPC code-based communication method, comprising:

obtaining an information bit sequence;
performing LDPC encoding on the information bit sequence based on an LDPC base matrix to obtain an LDPC coding bit sequence, wherein the LDPC base matrix is obtained based on a storage matrix and indication information, the indication information comprises first information and second information, the first information indicates one or more row pairs, each of the one or more row pairs corresponds to two rows of the storage matrix, a shifting value of a non-zero element in a first row of the two rows corresponds to a shifting value of a non-zero element in a second row of the two rows, the second information indicates one or more third rows, and the one or more third rows of the LDPC base matrix are the same as the one or more third rows of the storage matrix; and
sending the LDPC coding bit sequence.

**2.** A low-density parity-check LDPC code-based communication method, comprising:

receiving an LDPC coding bit sequence from a transmit end; and
decoding the LDPC coding bit sequence based on an LDPC base matrix, wherein the LDPC base matrix is obtained based on a storage matrix and indication information, the indication information comprises first information and second information, the first information indicates one or more row pairs, each of the one or more row pairs corresponds to two rows of the storage matrix, a shifting value of a non-zero element in a first row of the two rows corresponds to a shifting value of a non-zero element in a second row of the two rows, the second information indicates one or more third rows, and the one or more third rows of the LDPC base matrix are the same as the one or more third rows of the storage matrix.

**3.** The method according to claim 1 or 2, wherein

a row that is of the LDPC base matrix and that corresponds to the first row is the same as the first row; and
a row that is of the LDPC base matrix and that corresponds to the second row is obtained by performing elimination on the second row with the first row.

4. The method according to any one of claims 1 to 3, wherein
the storage matrix is obtained based on a first table, a second table, and a third table, the first table comprises a connection relationship between a variable node and a check node of the storage matrix, the second table comprises a shifting value of a non-zero element in a core matrix of the storage matrix, and the third table comprises a shifting value of a non-zero element in the one or more third rows.

5. The method according to any one of claims 1 to 4, wherein
a form used for the indication information comprises at least one of an indication sequence, a mapping table, or a mapping pair.

6. The method according to claim 5, wherein

the indication information is in a form of an indication sequence, and a length of the indication sequence is equal to a quantity of rows of the LDPC base matrix;
the first information comprises a row number of a second row in each of the one or more row pairs, a row number of a first row in the row pair is a position of the row number of the second row in the row pair in the indication sequence, and the position of the row number of the second row in the row pair in the indication sequence is greater than the row number of the first row in the row pair; and the second information comprises one or more first characters, and positions of the one or more first characters in the indication sequence correspond to row numbers of the one or more third rows.

7. The method according to claim 6, wherein
the first character is a value other than a row number of the storage matrix.

8. The method according to claim 6 or 7, wherein
the second information comprises a plurality of first characters, the plurality of first characters comprise at least two types of values, and third rows corresponding to first characters with a same value are pairwise orthogonal.

9. The method according to any one of claims 6 to 8, wherein

the indication sequence sequentially comprises a first segment, a second segment, a third segment, and a fourth segment; the first segment corresponds to the core matrix of the storage matrix, and the first segment consists of one or more first row numbers or one or more second characters; the second segment consists of one or more third characters; the third segment consists of one or more second row numbers; and the fourth segment is formed by interleaving one or more fourth characters and one or more third row numbers; and
the row number in the first information sequentially comprises the one or more first row numbers, the one or more second row numbers, and the one or more third row numbers, and the one or more first characters sequentially comprise the one or more second characters, the one or more third characters, and the one or more fourth characters.

10. The method according to claim 9, wherein
when the first segment consists of the one or more first row numbers, the one or more second row numbers comprise at least one or all of the one or more first row numbers.

11. The method according to claim 9 or 10, wherein
the one or more third row numbers comprise at least one or all of row numbers of third rows corresponding to the one or more fourth characters.

12. The method according to any one of claims 9 to 11, wherein
a proportion of the fourth characters in the fourth segment increases as a code rate corresponding to the LDPC base matrix decreases.

13. The method according to any one of claims 6 to 12, wherein
an $i^{th}$ position of the indication sequence is the first character, a quantity of pairwise orthogonal third rows in first i rows of the storage matrix is less than or equal to a sum of 1 and a maximum quantity of splitting times of rows corresponding to first (i - 1) positions of the indication sequence, and i is an integer greater than 1.

14. The method according to any one of claims 1 to 13, wherein

the storage matrix is an $M \times N$ matrix, the storage matrix comprises a submatrix A1, a submatrix B1, a submatrix C1, a submatrix D1, and a submatrix E1, the submatrix A1 is $1^{st}$ to $m_1{}^{th}$ rows and $1^{st}$ to $n_1{}^{th}$ columns of the storage matrix, the submatrix B1 is the $1^{st}$ to $m_1{}^{th}$ rows and $(n_1 + 1)^{th}$ to $n_2{}^{th}$ columns of the storage matrix, the submatrix C1 is the $1^{st}$ to $m_1{}^{th}$ rows and $(n_2 + 1)^{th}$ to $N^{th}$ columns of the storage matrix, the submatrix D1 is $(m_1 + 1)^{th}$ to $M^{th}$ rows and the $1^{st}$ to $n_2{}^{th}$ columns of the storage matrix, and the submatrix E1 is the $(m_1 + 1)^{th}$ to $M^{th}$ rows and the $(n_2 + 1)^{th}$ to $N^{th}$ columns of the storage matrix;
that the shifting value of the non-zero element in the first row corresponds to the shifting value of the non-zero element in the second row comprises: shifting values of non-zero elements in first $n_2$ elements of the first row correspond to shifting values of non-zero elements in first $n_2$ elements of the second row; and
the first $n_2$ elements of the second row are rows in a matrix formed by the submatrix A1 and the submatrix B1 or rows in the submatrix D1.

**15.** The method according to claim 14, wherein that the shifting values of the non-zero elements in the first $n_2$ elements of the first row correspond to the shifting values of the non-zero elements in the first $n_2$ elements of the second row comprises:

the shifting values of the non-zero elements in the first $n_2$ elements of the first row are properly comprised in the shifting values of the non-zero elements in the first $n_2$ elements of the second row; or
sums of a fixed value and the shifting values of the non-zero elements in the first $n_2$ elements of the first row are properly comprised in the shifting values of the non-zero elements in the first $n_2$ elements of the second row.

**16.** The method according to claim 14 or 15, wherein
the submatrix E1 is a lower triangular matrix.

**17.** The method according to any one of claims 1 to 16, wherein

a sum of column weights of a core part of the LDPC base matrix is less than a sum of column weights of a part that is of the storage matrix and that corresponds to the core part of the LDPC base matrix; and/or
a sum of column weights of an extended part of the LDPC base matrix is greater than a sum of column weights of a part that is of the storage matrix and that corresponds to the extended part of the LDPC base matrix.

**18.** The method according to any one of claims 1 to 17, wherein the method further comprises:

reading the indication information whose length is R based on a code length corresponding to the LDPC base matrix, a quantity of information bits corresponding to the LDPC base matrix, a quantity of punctured information columns, and a quantity of information columns in the LDPC base matrix; and
obtaining the LDPC base matrix based on the storage matrix and the indication information; wherein
R is a minimum integer that meets a condition $RZ_c \geq N_0 - K_0 + K_1$; $Z_c$ is a lifting value, and $Z_c$ is minimum $Z_c$ that meets a condition $KZ_c \geq K_0$ in a $Z_c$ list;
$N_0$ is the code length corresponding to the LDPC base matrix; $K_0$ is the quantity of information bits corresponding to the LDPC base matrix; K is the quantity of information columns in the LDPC base matrix; and $K_1$ is the quantity of punctured information columns.

**19.** A communication apparatus, comprising a module or unit configured to perform the method according to any one of claims 1 and 3 to 18 or the method according to any one of claims 2 to 18.

**20.** A communication apparatus, comprising:
a processor, configured to execute a computer program stored in a memory, to enable the apparatus to perform the method according to any one of claims 1 and 3 to 18 or the method according to any one of claims 2 to 18.

**21.** The apparatus according to claim 20, wherein the apparatus further comprises the memory.

**22.** The apparatus according to claim 20 or 21, wherein the apparatus is a chip.

**23.** A computer-readable storage medium, wherein the computer-readable storage medium stores a computer program, and when the computer program runs on a computer, the computer is enabled to perform the method according to any one of claims 1 and 3 to 18 or the method according to any one of claims 2 to 18.

**24.** A computer program product, wherein the computer program product comprises instructions for performing the method according to any one of claims 1 and 3 to 18 or the method according to any one of claims 2 to 18.

**25.** A communication system, comprising:

a transmit end, configured to perform the method according to any one of claims 1 and 3 to 18; and
a receive end, configured to perform the method according to any one of claims 2 to 18.

[FIG. 1]

$$
\begin{array}{c}
 \\ H =
\end{array}
\begin{array}{cccccccc}
V_1 & V_2 & V_3 & V_4 & V_5 & V_6 & V_7 & V_8
\end{array}
$$

$$
H = \begin{pmatrix}
1 & 0 & 1 & 0 & 1 & 0 & 1 & 0 \\
1 & 0 & 0 & 1 & 0 & 1 & 0 & 1 \\
0 & 1 & 1 & 0 & 0 & 1 & 1 & 0 \\
0 & 0 & 0 & 1 & 1 & 0 & 0 & 1
\end{pmatrix}
\begin{array}{c}
C_1 \\ C_2 \\ C_3 \\ C_4
\end{array}
$$

[FIG. 2]

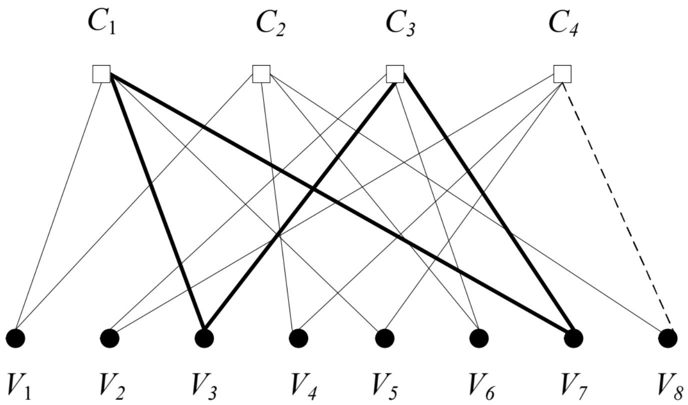


[FIG. 3]

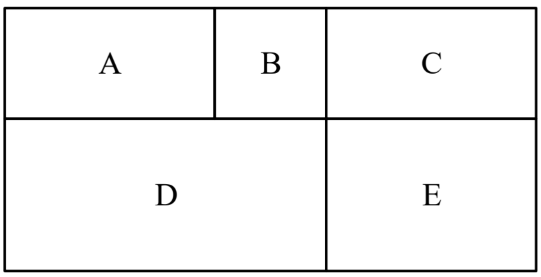

[FIG. 4]

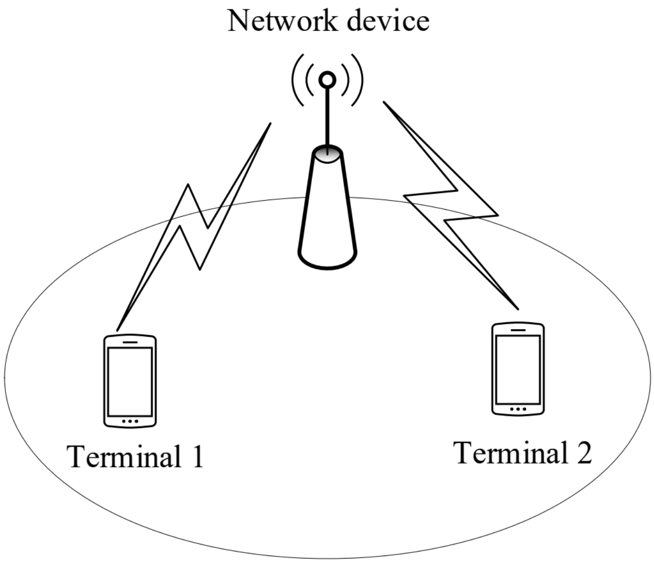
Network device
Terminal 1
Terminal 2

[FIG. 5]

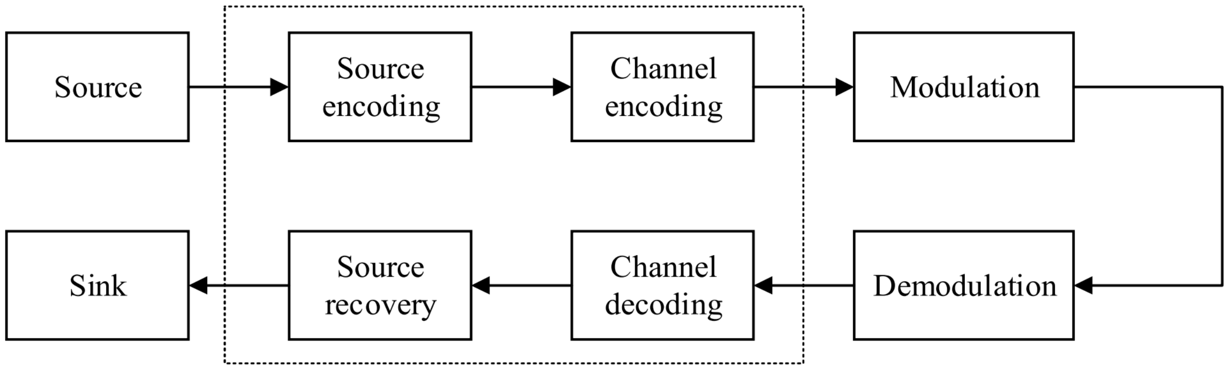
Source
Source encoding
Channel encoding
Modulation
Sink
Source recovery
Channel decoding
Demodulation

[FIG. 6]

600

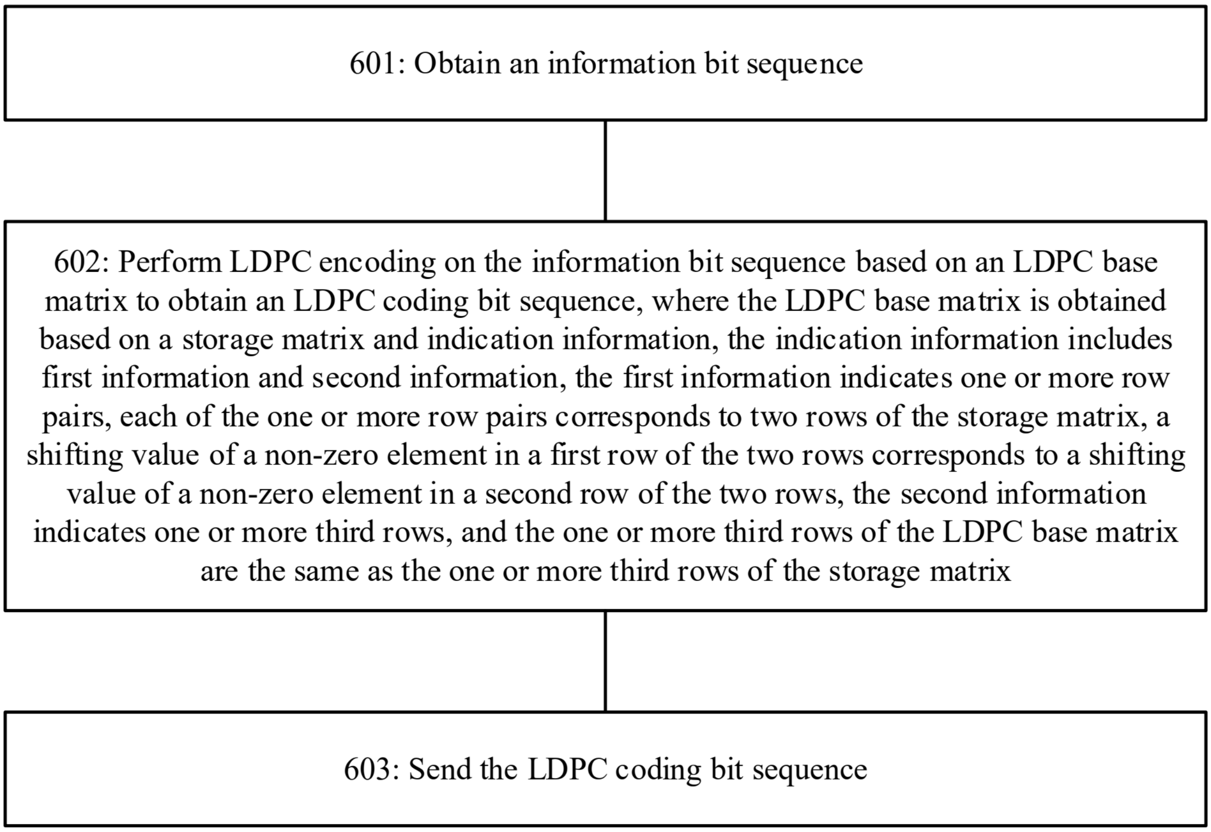
601: Obtain an information bit sequence
602: Perform LDPC encoding on the information bit sequence based on an LDPC base matrix to obtain an LDPC coding bit sequence, where the LDPC base matrix is obtained based on a storage matrix and indication information, the indication information includes first information and second information, the first information indicates one or more row pairs, each of the one or more row pairs corresponds to two rows of the storage matrix, a shifting value of a non-zero element in a first row of the two rows corresponds to a shifting value of a non-zero element in a second row of the two rows, the second information indicates one or more third rows, and the one or more third rows of the LDPC base matrix are the same as the one or more third rows of the storage matrix
603: Send the LDPC coding bit sequence

[FIG. 7]

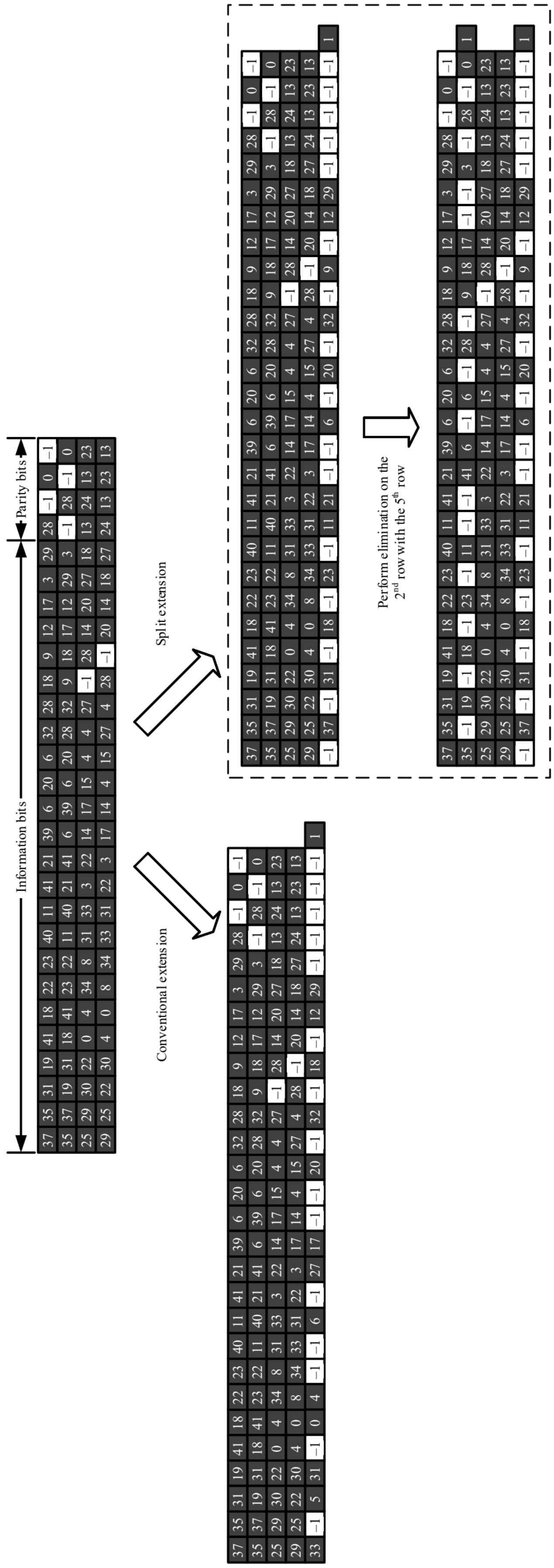
Information bits
Parity bits
Split extension
Conventional extension
Perform elimination on the 2nd row with the 5th row

[FIG. 8]

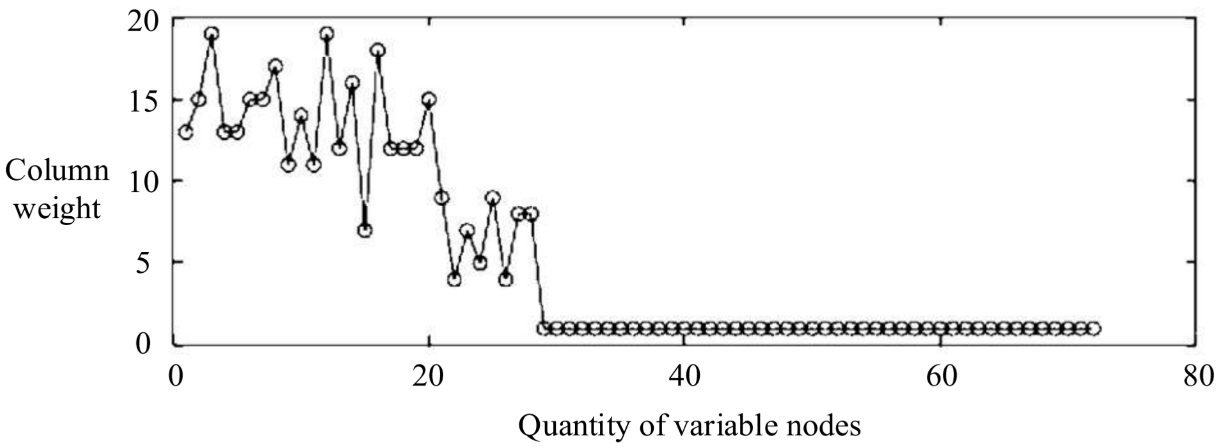
Column weight
20
15
10
5
0
0
20
40
60
80
Quantity of variable nodes

[FIG. 9]

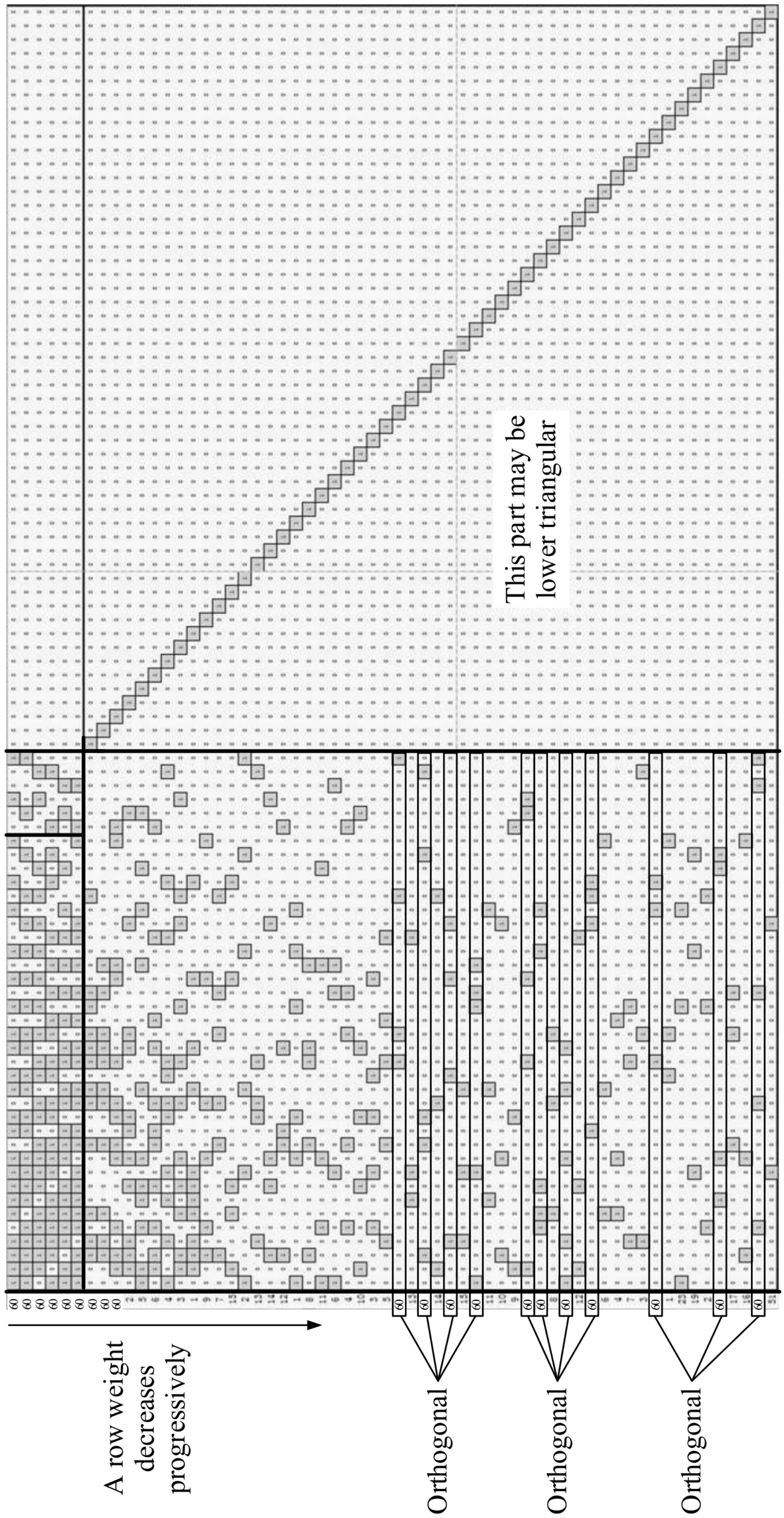
This part may be lower triangular
A row weight decreases progressively
Orthogonal
Orthogonal
Orthogonal

[FIG. 10]

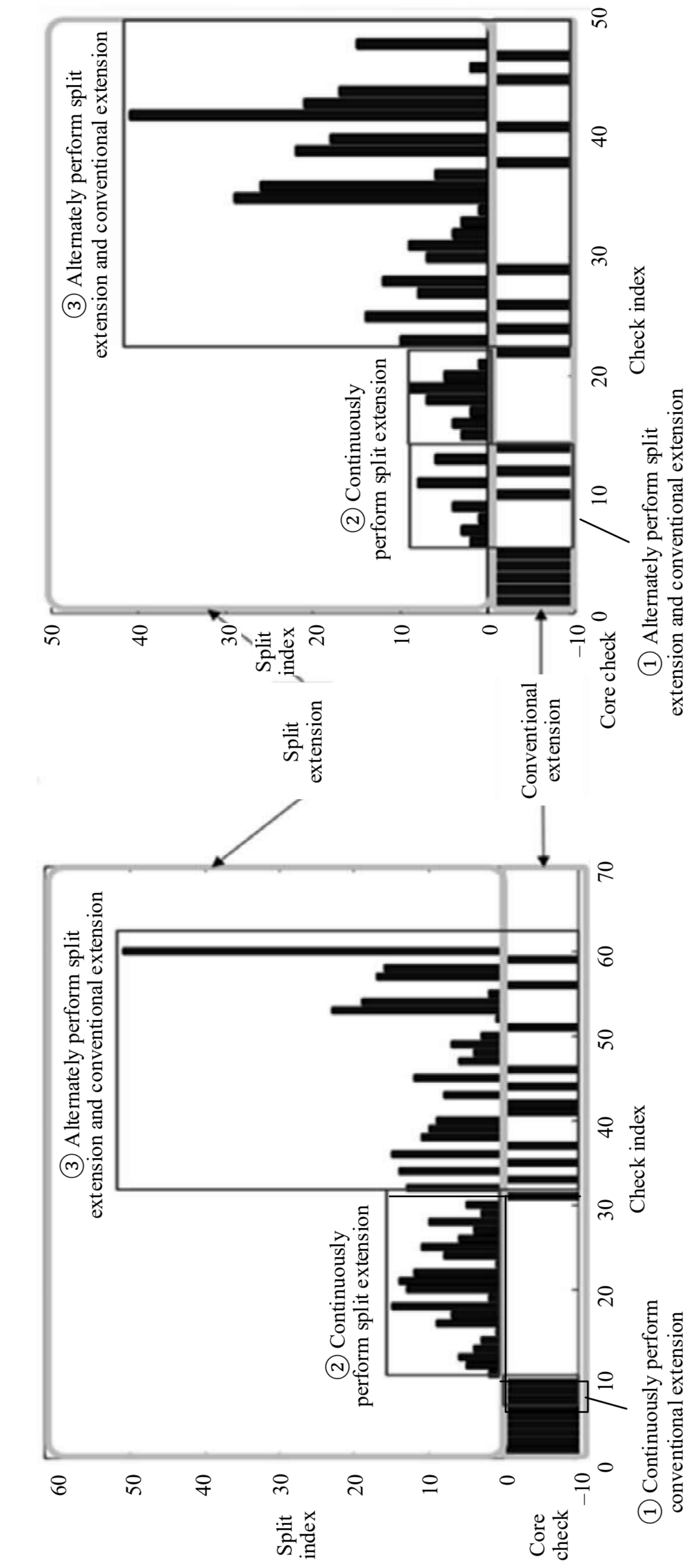

Split index
Core check
Check index
① Continuously perform conventional extension
② Continuously perform split extension
③ Alternately perform split extension and conventional extension
Split extension
Conventional extension
Split index
Core check
Check index
① Alternately perform split extension and conventional extension
② Continuously perform split extension
③ Alternately perform split extension and conventional extension

[FIG. 11]

1100

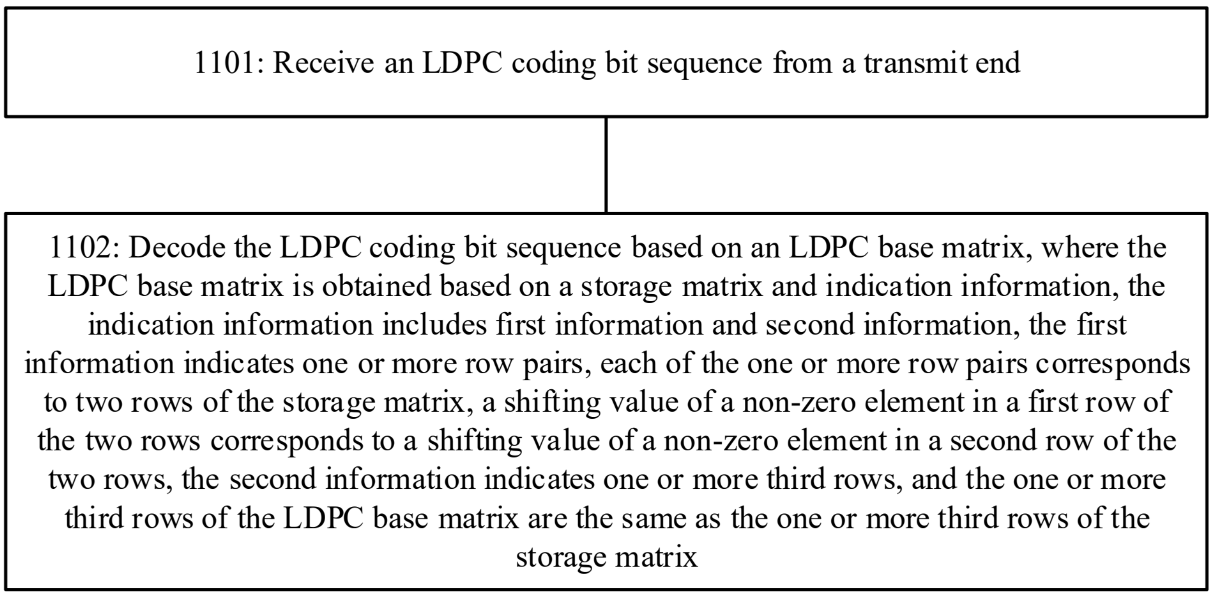
1101: Receive an LDPC coding bit sequence from a transmit end
1102: Decode the LDPC coding bit sequence based on an LDPC base matrix, where the LDPC base matrix is obtained based on a storage matrix and indication information, the indication information includes first information and second information, the first information indicates one or more row pairs, each of the one or more row pairs corresponds to two rows of the storage matrix, a shifting value of a non-zero element in a first row of the two rows corresponds to a shifting value of a non-zero element in a second row of the two rows, the second information indicates one or more third rows, and the one or more third rows of the LDPC base matrix are the same as the one or more third rows of the storage matrix

[FIG. 12]

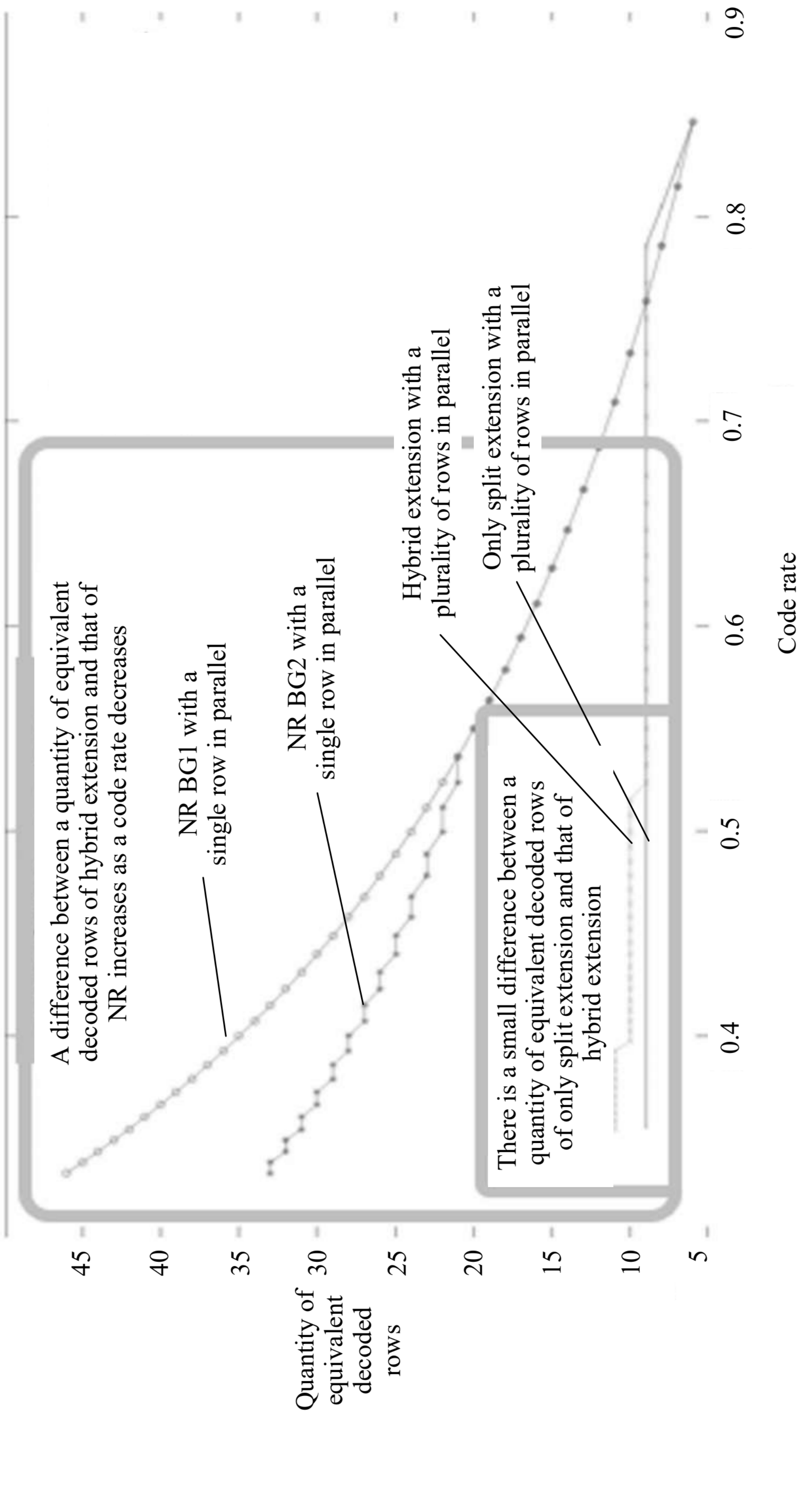
A difference between a quantity of equivalent decoded rows of hybrid extension and that of NR increases as a code rate decreases
NR BG1 with a single row in parallel
NR BG2 with a single row in parallel
Hybrid extension with a plurality of rows in parallel
Only split extension with a plurality of rows in parallel
There is a small difference between a quantity of equivalent decoded rows of only split extension and that of hybrid extension
Quantity of equivalent decoded rows
45
40
35
30
25
20
15
10
5
0.4
0.5
0.6
0.7
0.8
0.9
Code rate

[FIG. 13]

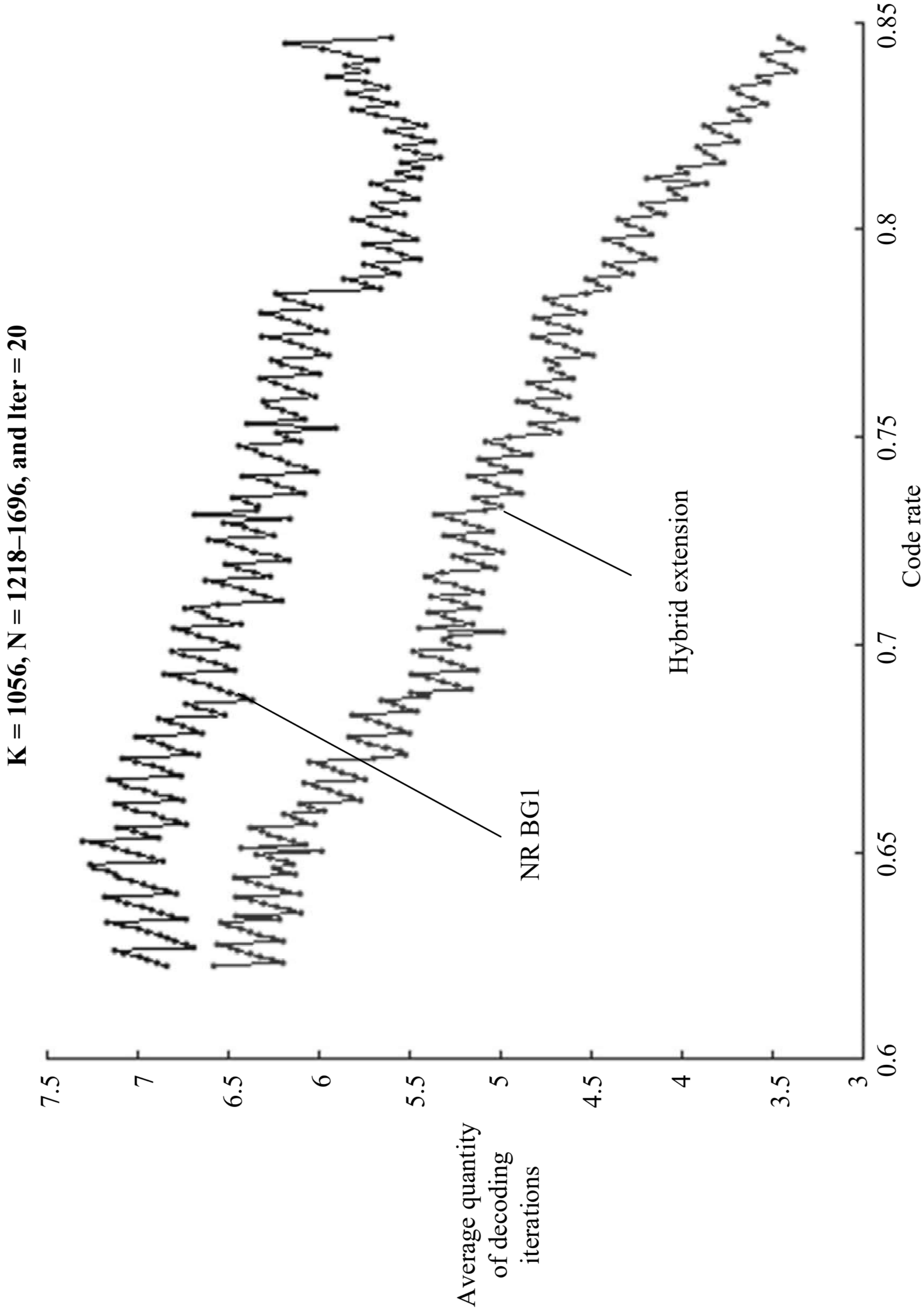
K = 1056, N = 1218–1696, and lter = 20
Average quantity of decoding iterations
7.5
7
6.5
6
5.5
5
4.5
4
3.5
3
0.6
0.65
0.7
0.75
0.8
0.85
Code rate
NR BG1
Hybrid extension

[FIG. 14]

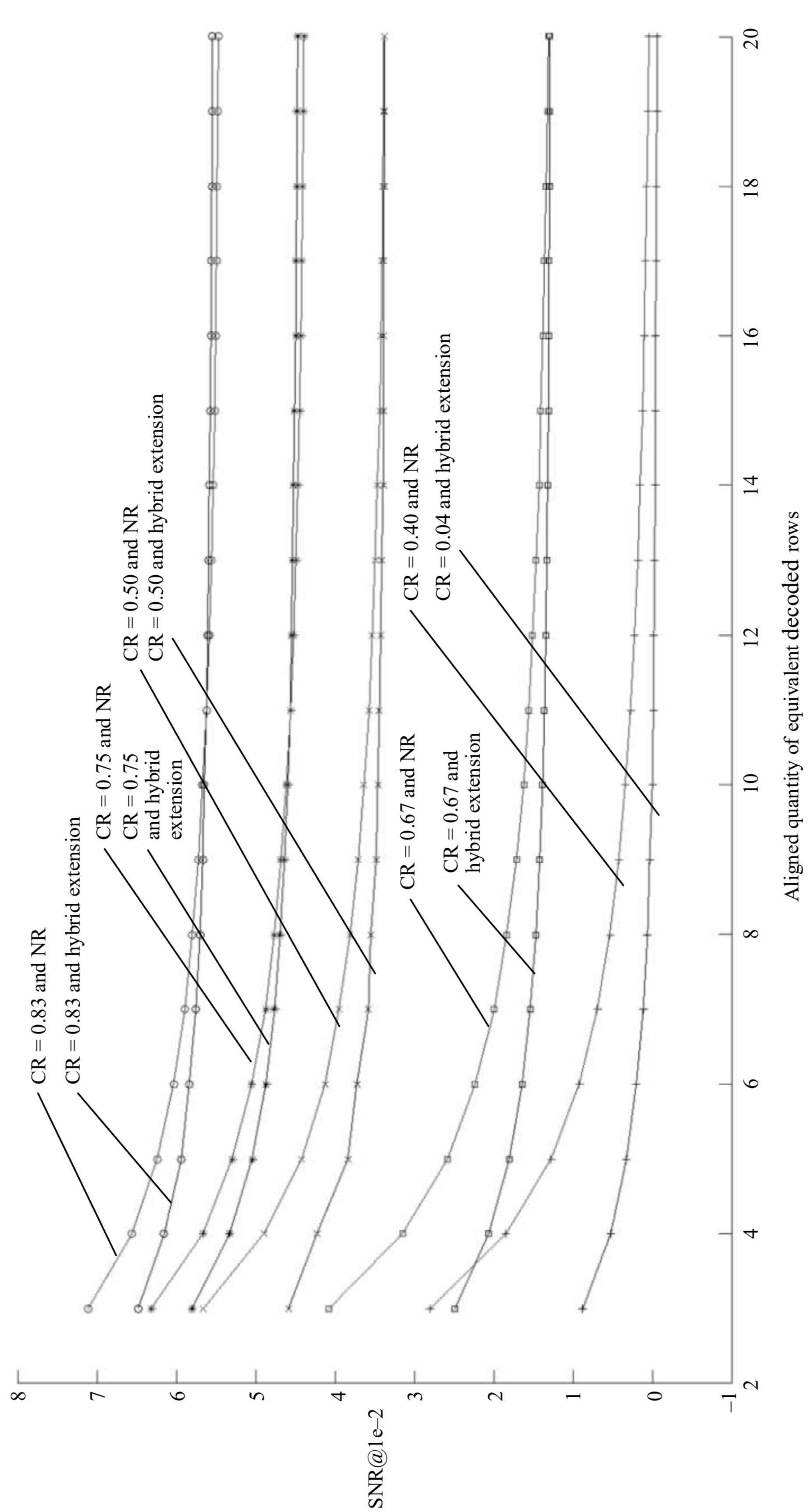
SNR@1e−2
Aligned quantity of equivalent decoded rows
CR = 0.83 and NR
CR = 0.83 and hybrid extension
CR = 0.75 and NR
CR = 0.75 and hybrid extension
CR = 0.50 and NR
CR = 0.50 and hybrid extension
CR = 0.67 and NR
CR = 0.67 and hybrid extension
CR = 0.40 and NR
CR = 0.04 and hybrid extension
8
7
6
5
4
3
2
1
0
−1
2
4
6
8
10
12
14
16
18
20

[FIG. 15]

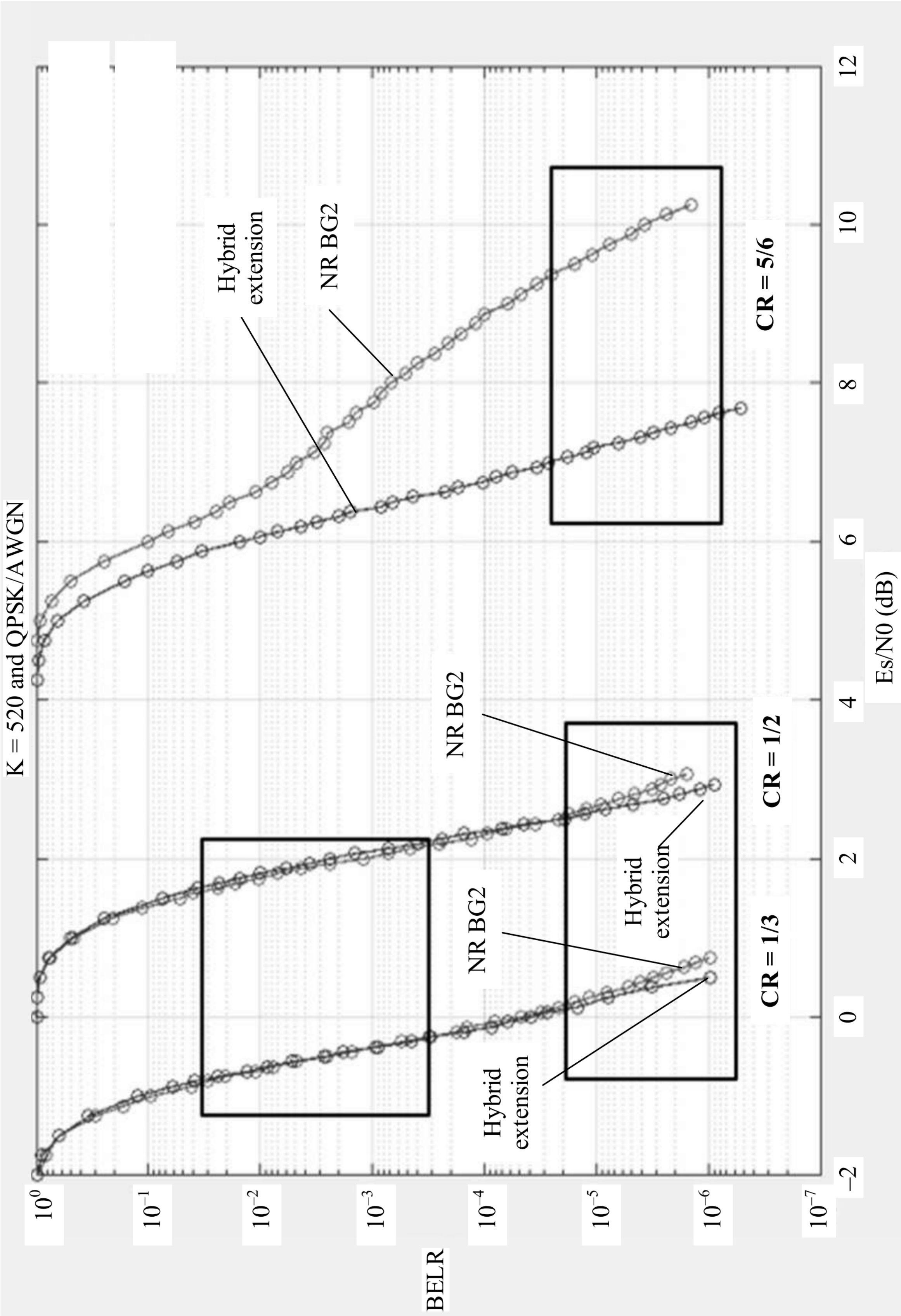
K = 520 and QPSK/AWGN
BELR
Es/N0 (dB)
CR = 1/3
CR = 1/2
CR = 5/6
NR BG2
Hybrid extension
NR BG2
Hybrid extension
NR BG2
Hybrid extension
$10^0$
$10^{-1}$
$10^{-2}$
$10^{-3}$
$10^{-4}$
$10^{-5}$
$10^{-6}$
$10^{-7}$
−2
0
2
4
6
8
10
12

[FIG. 16]

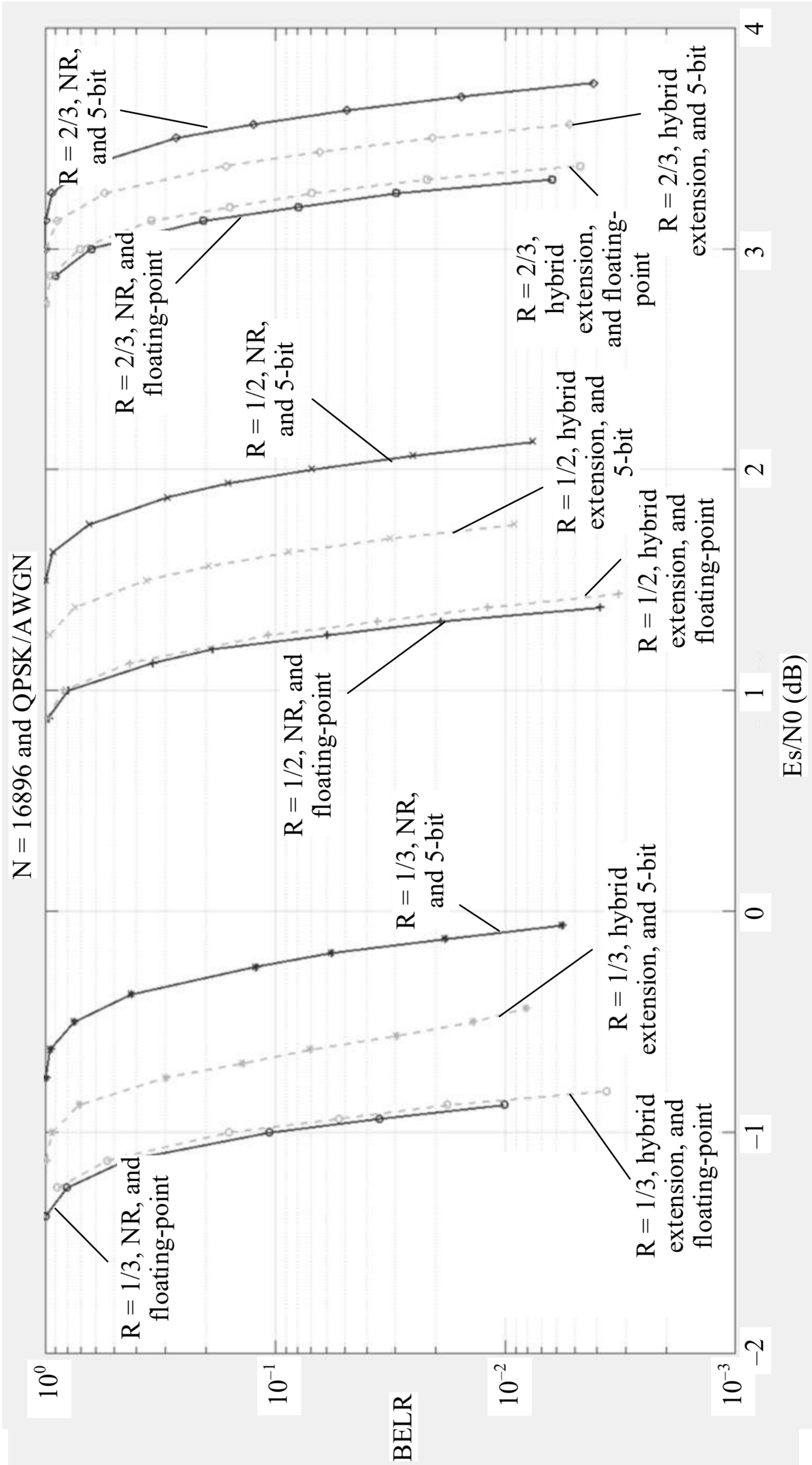

N = 16896 and QPSK/AWGN
BELR
$10^0$
$10^{-1}$
$10^{-2}$
$10^{-3}$
Es/N0 (dB)
−2
−1
0
1
2
3
4
R = 1/3, NR, and floating-point
R = 1/3, hybrid extension, and floating-point
R = 1/3, hybrid extension, and 5-bit
R = 1/3, NR, and 5-bit
R = 1/2, NR, and floating-point
R = 1/2, hybrid extension, and floating-point
R = 1/2, hybrid extension, and 5-bit
R = 1/2, NR, and 5-bit
R = 2/3, NR, and floating-point
R = 2/3, hybrid extension, and floating-point
R = 2/3, hybrid extension, and 5-bit
R = 2/3, NR, and 5-bit

[FIG. 17]

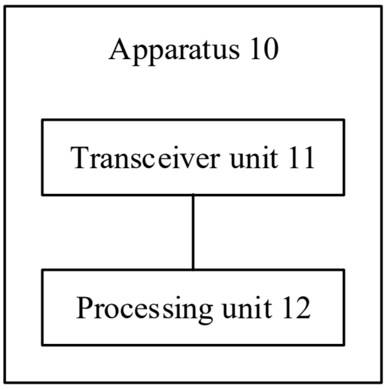
Apparatus 10
Transceiver unit 11
Processing unit 12

[FIG. 18]

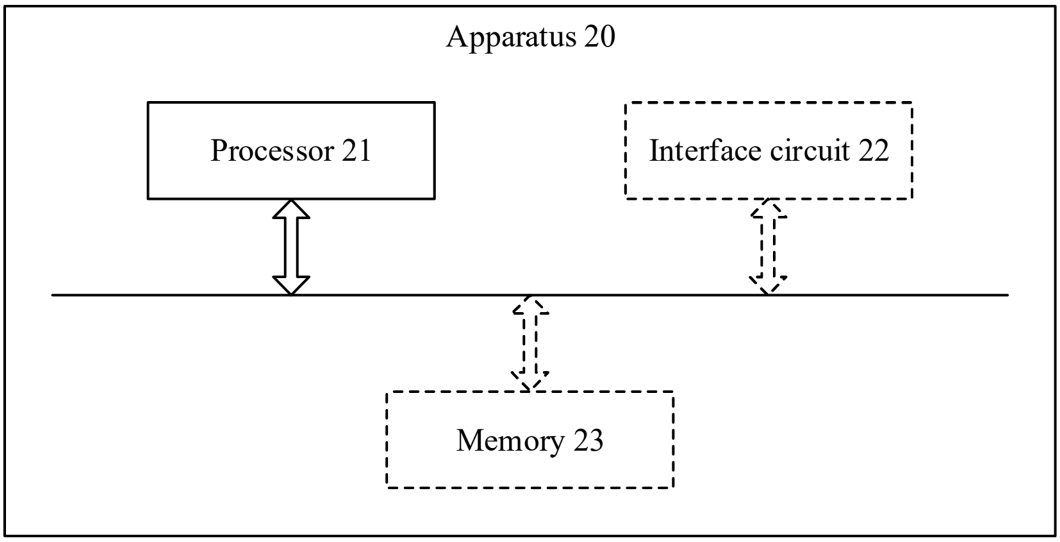
Apparatus 20
Processor 21
Interface circuit 22
Memory 23

**INTERNATIONAL SEARCH REPORT**

International application No.
**PCT/CN2023/073390**

**A. CLASSIFICATION OF SUBJECT MATTER**

H04L 1/00(2006.01)i; H03M13/11(2006.01)i

According to International Patent Classification (IPC) or to both national classification and IPC

**B. FIELDS SEARCHED**

Minimum documentation searched (classification system followed by classification symbols)

IPC:H04L H03M

Documentation searched other than minimum documentation to the extent that such documents are included in the fields searched

Electronic data base consulted during the international search (name of data base and, where practicable, search terms used)

CNTXT, ENTXTC, WPABSC, ENTXT, WPABS, CNKP, 3GPP: 低密度奇偶校验, 基矩阵, 基础矩阵, 编码, 存储矩阵, 行, 偏移, LDPC, base matrix, code, storage matrix, row, shift

**C. DOCUMENTS CONSIDERED TO BE RELEVANT**

| Category* | Citation of document, with indication, where appropriate, of the relevant passages | Relevant to claim No. |
|---|---|---|
| A | CN 108270510 A (HUAWEI TECHNOLOGIES CO., LTD.) 10 July 2018 (2018-07-10) entire document | 1-25 |
| A | CN 110710111 A (QUALCOMM INC.) 17 January 2020 (2020-01-17) entire document | 1-25 |
| A | CN 107370490 A (ZTE CORP.) 21 November 2017 (2017-11-21) entire document | 1-25 |
| A | US 2019268092 A1 (LG ELECTRONICS INC.) 29 August 2019 (2019-08-29) entire document | 1-25 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **06 September 2023** | **07 September 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | Telephone No. |

Form PCT/ISA/210 (second sheet) (July 2022)

**INTERNATIONAL SEARCH REPORT**
**Information on patent family members**

International application No.
**PCT/CN2023/073390**

| Patent document cited in search report | Publication date (day/month/year) | Patent family member(s) | Publication date (day/month/year) |
|---|---|---|---|
| CN 108270510 A | 10 July 2018 | None | |
| CN 110710111 A | 17 January 2020 | WO 2018227133 A1 | 13 December 2018 |
| | | TW 201909568 A | 01 March 2019 |
| | | TWI 775870 B | 01 September 2022 |
| | | JP 2021119685 A | 12 August 2021 |
| | | JP 7260587 B2 | 18 April 2023 |
| | | CA 3061475 A1 | 13 December 2018 |
| | | BR 112019025741 A2 | 23 June 2020 |
| | | US 2018358984 A1 | 13 December 2018 |
| | | US 10312939 B2 | 04 June 2019 |
| | | KR 20190140082 A | 18 December 2019 |
| | | KR 102178603 B1 | 13 November 2020 |
| | | EP 3635869 A1 | 15 April 2020 |
| | | TW 202249438 A | 16 December 2022 |
| | | JP 2020522951 A | 30 July 2020 |
| | | JP 6932791 B2 | 08 September 2021 |
| CN 107370490 A | 21 November 2017 | KR 20210032007 A | 23 March 2021 |
| | | KR 102347823 B1 | 05 January 2022 |
| | | KR 20190008335 A | 23 January 2019 |
| | | KR 102229233 B1 | 22 March 2021 |
| | | JP 2022058949 A | 12 April 2022 |
| | | US 2021091790 A1 | 25 March 2021 |
| | | US 11323134 B2 | 03 May 2022 |
| | | JP 2019517209 A | 20 June 2019 |
| | | JP 7025349 B2 | 24 February 2022 |
| | | EP 4231532 A2 | 23 August 2023 |
| | | US 2020244287 A1 | 30 July 2020 |
| | | US 10892778 B2 | 12 January 2021 |
| | | EP 3457575 A1 | 20 March 2019 |
| | | EP 3457575 A4 | 04 December 2019 |
| | | EP 3457575 B1 | 23 August 2023 |
| US 2019268092 A1 | 29 August 2019 | AU 2018246848 A1 | 26 September 2019 |
| | | AU 2018246848 B2 | 13 August 2020 |
| | | CL 2019002497 A1 | 20 December 2019 |
| | | WO 2018182369 A1 | 04 October 2018 |
| | | CA 3057817 A1 | 04 October 2018 |
| | | CA 3057817 C | 14 June 2022 |
| | | RU 2719688 C1 | 21 April 2020 |
| | | MX 2019009820 A | 28 November 2019 |
| | | PH 12019502212 A1 | 07 December 2020 |
| | | US 10484132 B2 | 19 November 2019 |
| | | US 2021203356 A1 | 01 July 2021 |
| | | US 11211951 B2 | 28 December 2021 |
| | | JP 2020517140 A | 11 June 2020 |
| | | JP 6974493 B2 | 01 December 2021 |
| | | EP 3605894 A1 | 05 February 2020 |
| | | EP 3605894 A4 | 25 November 2020 |
| | | SG 11201907654 TA | 27 September 2019 |
| | | BR 112019019253 A2 | 17 December 2019 |
| | | BR 112019019253 B1 | 10 November 2020 |

Form PCT/ISA/210 (patent family annex) (July 2022)

**INTERNATIONAL SEARCH REPORT**
**Information on patent family members**

International application No.
**PCT/CN2023/073390**

| Patent document cited in search report | Publication date (day/month/year) | Patent family member(s) | Publication date (day/month/year) |
|---|---|---|---|
| | | KR 20190006568 A | 18 January 2019 |
| | | KR 102065427 B1 | 13 January 2020 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- CN 2022132833 W